# EUROPEAN PATENT SPECIFICATION

(11) **EP 4 641 156 B1**
(45) Date of publication and mention of the grant of the patent: **16.09.2026**
(21) Application number: 25172540.4
(22) Date of filing: 25.04.2025
(51) Int. Cl.: G01K 3/00, G01K 7/01, G01K 7/02, H10D 12/00, H10D 62/00, H10D 30/67

(54) **A SWITCH DEVICE, A METHOD OF MANUFACTURING A SWITCH DEVICE AND A METHOD OF TAKING A MEASUREMENT**
SCHALTVORRICHTUNG, VERFAHREN ZUR HERSTELLUNG EINER SCHALTVORRICHTUNG UND VERFAHREN ZUR MESSUNG
DISPOSITIF DE COMMUTATION, PROCÉDÉ DE FABRICATION D'UN DISPOSITIF DE COMMUTATION ET PROCÉDÉ DE PRISE DE MESURE

(30) Priority: 25.04.2024 US 202463638864 P
(43) Date of publication of application: 29.10.2025
(73) Proprietor: Analog Devices International Unlimited Company, Limerick, V94 N4V2 (IE)
(72) Inventor: COYNE, Edward, Limerick, V94 RT99 (IE)
(74) Representative: Elkington and Fife LLP

(56) References cited:
- US-A1- 2008 237 738

## Description

### TECHNICAL FIELD

The present disclosure generally relates to the use of switch devices and sensors for detecting physical events, in particular, thermal events.

### BACKGROUND

The monitoring of systems and components which have been exposed to environmental changes may pose challenges since measuring devices used to monitor them must be able to withstand such environmental changes, which in some cases may be over a broad range or be at the extremes of those environmental changes, such as high temperatures. Further challenges for such monitoring involve the creation of a device wherein the measurements recorded cannot easily be offset or altered by an operator and which are persistent once recorded.
US 2008/237738 A1 disclose a cell comprising an active region between a first source/drain region and a second source/drain region, a gate insulating region disposed above the active region, a gate region disposed above the gate insulating region, and at least one metal structure below the first source/drain region or the second source/drain region.

### SUMMARY

According to the invention, there is provided a switch device, comprising a substrate; a p-n junction comprising a first p-doped layer provided on the substrate and a first n-doped layer provided on the substrate and opposing the first p-doped layer; a conduction layer provided on the substrate and extending from a first region adjacent the p-doped layer to a second region adjacent the n-doped layer, wherein the conduction layer comprises a plurality of charge carriers moveable within the conduction layer and wherein, in an initial state, the concentration of charge carriers in the first region is higher than in the second region; and wherein the first p-doped layer is vertically offset relative to the first n-doped layer to provide an offset region adjacent the first p-doped layer in which a plane parallel to the surface of the substrate extends through the offset region and the first n-doped layer; and wherein a part of the conduction layer defining at least a part of the first region is provided in the offset region such that an electric field generated by the p-n junction opposes the migration of the charge carriers from the first region to the second region.

According to an embodiment of the invention, there is provided a sensor for detecting a physical event, comprising: at least one switch device according to any of the embodiments disclosed herein; and a voltage generation device operably connected to the switch device so as to apply a voltage to the switch device, wherein the switch device is configured such that the voltage applied above a threshold voltage allows charge carriers to migrate from the first region to the second region wherein the voltage generation device is configured such that a physical event of a first magnitude causes the generation of a voltage above the threshold voltage.

According to the invention, there is provided a method of determining whether a physical event of a first magnitude has occurred, the method comprising: providing a sensor according to any of the embodiments disclosed herein; exposing the sensor to an environment in which a first physical event may occur such that a voltage at or above the threshold voltage is produced by the voltage generation device; and interrogating the sensor to determine whether the first physical event occurred.

According to the invention, there is provided a method of manufacturing a switch device, the method comprising: providing a substrate; depositing a conduction layer on the substrate, wherein the conduction layer extends from a first region adjacent the first p-doped layer to a second region adjacent the first n-doped layer, wherein the conduction layer comprises a plurality of charge carriers moveable within the conduction layer and wherein, in an initial state, the concentration of charge carriers in the first region is higher than in the second region; and forming a p-n junction by depositing a first p-doped layer on the substrate adjacent the first region and depositing a first n-doped layer on the substrate adjacent the second region and such that first n-doped layer opposes the first p-doped layer. The first p-doped layer is vertically offset relative to the first n-doped layer to provide an offset region adjacent the first p-doped layer in which a plane parallel to the surface of the substrate extends through the offset region and the first n-doped layer. A part of the conduction layer defining at least a part of the first region is provided in the offset region such that an electric field generated by the p-n junction opposes the migration of the charge carriers from the first region to the second region.

Those skilled in the art will recognize additional features and advantages upon reading the following detailed description, and upon viewing the accompanying drawings.

### BRIEF DESCRIPTION OF THE DRAWINGS

Devices and methods will now be described by way of embodiments with reference to the accompanying drawings, in which:
Fig. 1 schematically depicts a cross-sectional side view of a switch device according to an embodiment;
Fig. 2 schematically depicts a cross-sectional side view of a switch device according to an embodiment;
Figs. 3A-3F schematically depict a cross-sectional side views of the manufacture of a switch device according to an embodiment;
Figs. 4A-4F schematically depict a cross-sectional side views of the manufacture of a switch device according to an embodiment;
Figs. 5A-5C schematically depict a cross-sectional side views of the manufacture of a switch device according to an embodiment;
Fig. 6A schematically depicts a plan view of a sensor according to an embodiment;
Fig. 6B schematically depicts a sensor according to an embodiment;
Fig. 6C schematically depicts the sensor of Fig. 6B according to an embodiment;
Fig. 7 schematically depicts a plan view of a system according to an embodiment;
Figs. 8a-d schematically depicts different switching devices according to embodiments;
Fig. 9 depicts a method of interrogating a switch device according to an embodiment; and
Fig. 10 depicts a method of manufacturing a switch device according to an embodiment.

It should be noted that these figures are diagrammatic and not drawn to scale. Relative dimensions and proportions of parts of these figures have been shown exaggerated or reduced in size, for the sake of clarity and convenience in the drawings.

### DETAILED DESCRIPTION

The following description sets forth exemplary aspects of the present disclosure. It should be recognized, however, that such a description is not intended as a limitation on the scope of the present disclosure. Rather, the description also encompasses combinations and modifications to those exemplary aspects described herein.

A switch device is disclosed, comprising: a substrate; a p-n junction comprising a first p-doped layer provided on the substrate and a first n-doped layer provided on the substrate and opposing the first p-doped layer; a conduction layer provided on the substrate and extending from a first region adjacent the p-doped layer to a second region adjacent the n-doped layer, wherein the conduction layer comprises a plurality of charge carriers moveable within the conduction layer and wherein, in an initial state, the concentration of charge carriers in the first region is higher than in the second region; and wherein the first p-doped layer is vertically offset relative to the first n-doped layer to provide an offset region adjacent the first p-doped layer in which a plane parallel to the surface of the substrate extends through the offset region and the first n-doped layer; and wherein a part of the conduction layer defining at least a part of the first region is provided in the offset region such that an electric field generated by the p-n junction opposes the migration of the charge carriers from the first region to the second region.

The device accordingly provides a structure which acts as a dual-gate field effect transistor (FET, or MOSFET). In this way, there is a first FET or gate structure comprising the first p-doped layer which forms a first metal oxide semiconductor (MOS) FET with the substrate and a second FET or gate structure comprising the first n-doped layer which forms a second MOSFET with the substrate. The conduction layer can be provided between the first p-doped layer and the substrate and, similarly, between the first n-doped layer and the substrate and extends therebetween so that it provides a diffusion pathway between these structures for the charge carriers. The first gate structure has the higher concentration region (i.e. the first region) adjacent it (which can be between the first p-doped layer and the substrate) and the second gate structure has the lower concentration region (i.e. the second region) adjacent it (which can be between the first n-doped layer and the substrate). In this state, because the first n-doped layer and first p-doped layer are electrically separated and the first region is separate from the first n-doped layer, the second gate has a first state (which can be considered to be "off").

The two regions within the conduction layer - the first region comprising a higher concentration of charge carriers (in an initial state) and a second region having a lower concentration (in the initial state) mean that the charge carriers will seek to move through the conduction layer from the higher concentration region to the lower concentration region; however, the charge carriers in the first region and are held in the first region by an electric field acting in opposition which prevents them from moving to the second region - i.e. as an electrostatic barrier.

When a threshold voltage is applied to the switching device, it switches off the electric field within the switching device and allows the charge carriers to move from the first region to the second region. Specifically, the application of the voltage charges the gate of one MOSFET (e.g. the first gate) to the threshold voltage, which reduces or turns off the electric field. With the electric field off or reduced, charge carriers can flow across the conduction layer to the second region. The second MOS, which is initially in the first state (e.g. off) because of the second region located between the first n-doped layer and the substrate now has charge carriers between these layers and forms another, detectable state (e.g. "on"). This turning of the second MOS enables a user to determine the state of the switch device, for example because the threshold voltage of the device itself has changed. The device can therefore be interrogated (e.g. through the application of a voltage) to the second gate (i.e. the comprising first n-doped layer) to determine whether the charge carriers are in the second region or not.

By designing the geometry of the switch device such that the opposition to the flow of charge from the first region to the second region down a concentration gradient is achieved without power, this may enable the switch device to able to retain the data stored within it when power is not present. Specifically, the device of the present disclosure provides a p-n junction which generates an electric field which opposes the migration of charge carriers from the first region to the second region. This accordingly directly opposed the move, as opposed to simply interfering with movement (e.g. where an electric field is perpendicular to the direction that charge carrier must move in order to migrate from a first region to a second region), which may not retain these in the first region sufficiently. It follows that sensors incorporating such switching devices can more robustly record and store data.

As set out above, the monitoring of systems and components which have been exposed to environmental changes may pose challenges since measuring devices used to monitor them must be able to withstand such environmental changes, which in some cases may be over a broad range or be at the extremes of those environmental changes, such as high temperatures. If components experience excessive or repeated environmental heat exposure, then those components may deteriorate, leading to safety concerns and potential failure of wider systems. Accordingly, monitoring and recording thermal exposure for further analysis and to flag unexpected conditions may be of vital importance. For example, in the context of medical devices (e.g. surgical devices), these often require sterilisation but may only be expected to be able to survive a certain number of sterilisation cycles (e.g. using an autoclave). Accurate means of tracking the number of these cycles is required to avoid either unnecessary discarding of devices or use of devices where the device has unknowingly exceeded its safe exposure limits.

In some conventional cases, monitoring of the exposure of components to conditions relies on manual records. These recording methods are prone to errors, such as misidentification of components, erasure or loss of records, or even failure to record exposure.
In other cases, users may not even be aware of the exposure. The device of the present disclosure provides advantages over this type manual recording in that it is a persistent and automatic record which cannot easily be offset or altered by an operator. Further, the use of a specific device means that each component or device being tracked is provided with a specific memory associated therewith. This allows the physical encoding of information regarding the history of a component, improving the reliability and accuracy of data.

Exposure monitoring systems can be used e.g. to monitor exposure to certain conditions, such as thermal exposure, but it is important to ensure that they are reliable and accurate. The present disclosure provides switch devices and sensors which provide a more robust way of recording and storing information relating to the occurrence of an environmental condition.

As set out above, the switch device has a structure in which the state of the switch is based on the position of charge carriers within the conduction layer. The switch device has a default, initial state in which the movement of charge carriers from the first region to the second region (which is energetically favourable in isolation (e.g. under time and temperature) due to the different concentrations of charge carriers in each) is opposed through an electric field generated by the p-n-junction. Once a certain input threshold is reached, the device is configured such that the charge carriers can be moved from the first region to the second region under a stimulus which eliminates or reduces the strength of the electric field generated by the p-n-junction. This can be applied to or across the first gate structure (i.e. the first MOSFET) which reduces or eliminates the field across the p-n-junction and removes the resistance to charge carrier movement. This stimulus can be linked to the environmental conditions and may be converted from the environmental condition to an electrical input. As such, information regarding whether the conditions were present can be recorded by determining the location of the charge carriers and assessing whether a stimulus sufficient for the charge carriers to pass through an electric field which opposes their motion down a diffusion concentration gradient has occurred.

Further, once in this state, the storage is more robust as it is in an energetically favourable state. Rather than having a digital signal or an external record which corresponds to a component, the history of a component (e.g. the thermal history) may be physically encoded via the position of charge carriers. This means that the device is a passive storage device. As such, the data is not dependent on power being maintained and can be less prone to failure or loss of data.

Further, the means by which this is stored is more difficult to tamper with - the movement of the charge carriers is no longer energetically favoured as the first and second regions have the same (or a reduced) charge differential. Switch devices and sensors are typically designed operable over the parameter range that they used in. Some switch devices and sensors may, above or below certain critical values develop a non-linear and unpredictable response to the parameter that they are measuring meaning that measurements taken are not accurate. This may be due to the breakdown of complex circuitry. The disclosed switch device and sensor may provide a decreased likelihood of breakdown because the switch device uses the geometry of the layers and p-n junction to provide retention of charge carriers, rather than relying on an external store of power.

The switch device of the present disclosure may facilitate the recording of data without the need for a dedicated store of power. Powering electronic components often requires a dedicated power store, such as a battery or continuous electricity supply. There are several challenges that exist when trying to utilise batteries and power sources within environments when there are changing conditions such as temperature and pressure and, if not managed properly this can lead to the battery, power source and their associated components melting and/or exploding. Furthermore, it is challenging to waterproof such components and protect them against acidic or alkaline conditions. The present device provides passive switching and data storage. For example, the switch device of the present disclosure may record an environmental condition without a dedicated power store. For the charge carriers to move through the electric field, the sensor may be configured so that energy can be supplied from environmental changes. When there is no source of power present, the switch device retains the charge carriers such that they cannot freely move through the structure. This increases the security of such devices as they cannot be tampered with. Furthermore, this prevents records from being erased.

### P-n junction

The opposition to the charge carrier movement is provided by the p-n junction and the conduction layer geometry. Specifically, a part of the conduction layer defining at least a part of the first region is provided in the offset region such that an electric field generated by the p-n junction (i.e. between the first p-doped layer and the first n-doped layer) opposes the migration of the charge carriers from the first region to the second region. A p-n junction is formed through the first p-doped layer and first n-doped layer being adjacent one another but electrically separated such that they do not provide an electrical short therebetween. The p-n junction in the present devices comprises the first n-doped layer and first p-doped layer. As set out above, the movement of these charge carriers occurs due to a diffusion concentration gradient formed in the conduction layer between the first and second regions.

Accordingly, rather than an electric field generated by the p-n junction merely being a byproduct of device fabrication, the p-n junction provides the electric field which itself opposes the migration of the charge carriers from the first region to the second region. If the electric field holding the charge carriers in the first region was only perpendicular, the charge carriers may be more susceptible to movement from the first region to the second regions. Instead, by providing a part of the conduction layer defining at least a part of the first region in the offset region, it is possible to make use of the electric field generated by the p-n junction to confine the plurality of charge carriers within the first region since the electric field directly opposes the movement.

In other words, the first n-doped layer (acting as a first gate) and first p-doped layer (acting as a second gate) may therefore form a gate which is closed to the charge carriers in a first state and which is open in a second state, for example when a voltage greater than or equal to a threshold voltage is applied to the device. The threshold voltage is the voltage which when applied to the device causes carriers to move from the first region to the second region. A specific threshold voltage within a switch device may be achieved by adjusting factors such as the distance between the first p-doped layer and the first n-doped layer, the conduction layer thickness, the number of sub-layers in the conduction layer, the conduction layer material(s) and the degree of offset between the first p-doped layer and first n-doped layer. The charge carriers may therefore be temporarily confined to a first region such that they are opposed in their motion to a second region due to the presence of the electric field generated by the first n-doped and first p-doped layers. The present disclosure accordingly provides a switch device in which there is a component of the electric field generated by the first p-doped and first n-doped layer which opposes the motion of the charge carriers down a concentration gradient.

The threshold voltage may be at least 0.1V, at least 0.3V, at least 0.5V or at least 0.7V. The threshold voltage may be up to 0.3V, up to 0.5V, up to 0.7V, up to 1V, up to 2V, up to 5V or up to 10V. For example, the threshold voltage may be in a range from 0.1 to 5V, in a range from 0.1 to 3V, in a range from 0.5 to 3V, in a range from 0.5 to 1V or in a range from 0.6-0.8V.

The first p-doped layer and n-doped layer are separated so as to avoid electrical shorting between the two.

### Physical encoding

Within a conventional metal oxide semiconductor field effect transistor (MOSFET) device, two voltages can be applied. The first voltage, known as the gate voltage, facilitates the creation of a channel between a source and drain. This channel may be temporary. The channel between the source and the drain is perpendicular to the direction in which the gate voltage is applied. A second voltage can be applied between a source and a drain which facilitates the flow of charge carriers through this channel and provides an output indicative of the state of the channel. Since the arrangement requires two voltages, within an environment in which there is high temperature, high pressure and/or other conditions which can cause the breakdown of electronic components, conventional MOSFET devices may become unpredictable, especially if the devices are used as part of a switch device and further within a sensor. In contrast, within the device of the present disclosure, an electric field is generated by the p-n junction which opposes the migration of the charge carriers from a first region to a second region. This may have the advantage of holding charge carriers within a first region without the application of power providing a first state. Then, once a threshold voltage is applied, the charge carriers move to a second state. It is then possible to determine whether the charge carriers have been provided with a first voltage greater than the threshold voltage by determining the charge carrier concentration at different regions within the switch device, for example by applying a voltage across the second gate or second MOSFET. This is a simplified arrangement since the switch device can operate without the need for a second voltage to be applied to facilitate the movement of charge; instead, the change in state is recorded and passively held and can be determined at a later stage.

### Laver arrangement

The layers disclosed herein may be single, unitary layers or may each be formed of sub-layers. The layers are disposed on or connected to the substrate and other layers. By "disposed on, it is meant that the layers may be direct contact with the substrate or other layers (i.e. disposed directly on) or may be disposed on or connected to the substrate or other layers through one or more additional layers which are in-between each of these layers and the substrate. For example, by a first n-doped layer provided on the substrate and a first p-doped layer provided on the substrate, it is meant that the first n-doped and first p-doped layers are disposed on or connected to the substrate. The first n-doped layer and first p-doped layer may be in direct contact with the substrate, or the first n-doped layer and/or the first p-doped layer may be disposed on or connected to the substrate through one or more additional layers which are in-between each of these layers and the substrate.

The first p-doped layer is vertically offset relative to the first n-doped layer to provide an offset region adjacent the first p-doped layer in which a plane parallel to the surface of the substrate extends through the offset region and the first n-doped layer. When reference is made to being vertically offset, this means vertically offset or aligned in a direction of a direction vector that moves away or toward the substrate surface. This may optionally mean offset or aligned in a direction normal to the plane of the substrate surface. Vertically offset still allows for in-plane alignment of layers such that the layers do not directly overlay each other. For example, the first p-doped layer may be vertically offset from the plane of the base of the first n-doped layer in a direction away from the substrate surface such that there is no overlay between the first n-doped layer and first p-doped layer. The term "vertically offset", therefore, does not require that the first p-doped layer is directly above the first n-doped layer when considering a direction normal to the surface of the substrate. Instead, the term "vertically offset" allows for there to also be a horizontal offset in a direction parallel with the substrate surface. The offset region is an area on the substrate where first p-doped layer and first n-doped layer are out of alignment such that a plane (or linear extension) parallel to the surface of the substrate can extend through first n-doped layer but which does not extend through the first p-doped layer. Through this offset region, which is adjacent (i.e. abutting or next to but spaced from) the first p-doped layer, a plane parallel to the surface of the substrate can extend through and the first n-doped layer. A part of the conduction layer which defines at least a part of the first region is provided in the offset region, meaning this offset region is at least partially occupied by (i.e. comprises) the conduction layer.

There are several arrangements or geometries in which a vertically offset first p-doped layer will facilitate the creation of an electric field opposing the migration of the charge carriers form the first region to the second region.

By "substrate surface", it is meant a surface upon which the conduction layer, first p-doped layer and first n-doped layer are provided (either directly on or indirectly on). As such, the reference to in a direction away from the substrate surface refers to a direction from the substrate surface and towards the layers which are present upon the substrate surface. The substrate surface may form a plane.

The first p-doped layer may be provided directly on the conduction layer in the offset region. In other words, the conduction layer may extend into the offset region and contact a part of the first p-doped layer defining the offset region. Such a configuration allows for the electric field generated by the p-n junction to be arranged such that the charge carriers within the first region adjacent (i.e. abutting or next to but spaced from) the p-doped layer are more reliably confined within this region. This is because the direct connection between the conduction layer and the first p-doped layer contributes to minimising the distance between the conduction layer, which is present in the first region, and the first p-doped layer. Furthermore, this arrangement contributes to avoiding any electric fields from materials between the conduction layer and the first p-doped layer which may counteract the electric field generated by the p-n junction. Such a configuration may therefore contribute to the device functioning more reliably.

The plane of the base of the first p-doped layer may be vertically offset from plane of the base of the first n-doped layer in a direction away from the substrate surface. By base of the first n-doped layer and base of the first p-doped layer it is meant the parts of these layers which are closest to the substrate surface. The plane of the upper surface of the first p-doped layer may be vertically offset from plane of the upper surface of the first n-doped layer in a direction away from the substrate surface. By upper surface of the first n-doped layer and upper of the first p-doped layer it is meant the parts of these layers which are furthest away from the substrate surface. The first p-doped layer as a whole may be vertically offset from the first n-doped layer as a whole in a direction away from the substrate surface.

The first p-doped layer may comprise an overlap region in which a plane parallel to the surface of the substrate extends through the overlap region and the first n-doped layer. By overlap region, it is meant a region of the first p-doped layer which shares a plane with the first n-doped layer, wherein the plane is parallel to the substrate surface. The presence of a plane parallel to the surface of the substrate which extends through the overlap region and the first n-doped layer allows for a switch architecture which more precisely opposes the migration of the charge carriers from the first region to the second region. The conduction layer may be placed at least partially in contact within the overlap region in the offset region meaning that the charge carriers within the conduction layer experience an increased electric field which is more precisely directed in opposition to migration from the first region to the second region. As such, confining the charge carriers which are at a higher concentration in the first region may be achieved with more precision. If the conduction layer is in the same plane as the first n-doped layer this may enable the electric field to be generated such that the electric field is stronger than when the first conduction layer and the first n-doped layer are not co-planar. Such an arrangement may contribute to a decrease in stray charges towards the edge of the electric field having enough energy to overcome the electric field. A stronger electric field therefore may contribute to more reliable and predictable sensor behaviour.

The first p-doped layer or first n-doped layer may further extend over the top of the other of the first p-doped layer or first n-doped layer, relative to the substrate. However, these parts may be electrically insulated from one another to ensure the generation of the electrical field. For example, a barrier layer may be provided between any part of one of these layers which is located over the other.

A second n-doped layer may be provided on the substrate. The presence of a second layer facilitates several arrangements which allow for the electric field to be adjusted such that the charge carriers are better retained in the first region. For example, a second n-doped layer may be used to provide enhanced opposition to the charge carriers moving from the first region to the second region. Either of the first or second n-doped layer may be provided between the substrate the first conduction layer. Such an arrangement allows one of the n-doped layers to provide a field vector which is diagonal to the surface of the conduction layer and for the other n-doped layer to provide field vectors which are normal to the conduction layer surface. Within such a configuration, the electric field which is normal to the conduction layer surface may provide a force which acts on the charge carriers and directs them towards the first p-doped layer. As such, the two layers may combine to produce a synergistic effect.

### P- and n-doped layer materials

Doping refers to the addition of an element or elements to a semiconductor. Many n-doped, also referred to as n-type, and p-doped, also referred to as p-type semiconductors, are available which may be used within the disclosed switch device p-doped and n-doped layers.

Any of the n-doped layers may comprise one or more of the following: Si doped with one or more of P, As, Bi and Sb and Ge doped with one or more of P, As, Bi and Sb. The n-doped layer may optionally be in polycrystalline form. For example, the n-doped layers within the switch device may consist of Si doped with one or more of P, As, Bi and Sb. Alternatively the n-doped layers within the switch device may consist of Ge doped with one or more of P, As, Bi and Sb.

Any of the p-doped layer(s) may comprise one or more of the following Si doped with one or more of B, Ga, Al and In and Ge doped with one or more of B, Ga, Al and In. For example, the first p-doped layer may be in the form of SiGe, which is optionally in a polycrystalline form. This SiGe may be doped with one or more of B, Ga, Al and In. The p-doped layer(s) may consist of Si doped with one or more of B, Ga, Al and In. Alternatively, the p-doped layer(s) may consist of Ge doped with one or more of B, Ga, Al and In.

### Conduction layer

By conduction layer, it is meant a layer which comprises a plurality of charge carriers (e.g. positive ions, such as positive alkali ions) and through which the charge carriers are moveable. By plurality, it is means more than one charge carrier, this may either be more than one charge carrier of the same type (e.g. Na⁺ only), or multiple charge carriers of different types (e.g. Na⁺, Li⁺ and Ca²⁺).

The conduction layer serves the purpose of providing charge carriers and to provide a medium through which the charge carriers are able to move through the circuit.

These charge carriers experience an electric field which is generated by the p-n junction which opposes their migration from the first region to the second region. Since there is an electric field generated by the first n-doped layer and the first p-doped layer opposing the motion of charge carriers through it, a region of higher concentration of charge carriers may develop for charge carriers which have not passed through the electric field. Charge carriers present within the electric field may therefore move to a region of lower potential energy by moving with the electric field, thus further contributing to the region of higher charge carrier density within the conduction layer.

The conduction layer may be provided between the first p-doped layer and the substrate and between the first n-doped layer and the substrate. Such a configuration allows for the conduction layer to extend through a region which is between the first n-doped layer and the substrate. As such, the conduction layer may both define a part of the first region, be provided in the offset region and be present between the first n-doped region and the substrate. In both cases, a pathway may be provided for the charge carriers within the conduction layer to move from the first region to the second region through the switch device provided that the charge carriers overcome the opposition to their migration provided by the electric field. Such a path may help to facilitate the movement of the charge carriers from a higher concentration in the first region in the initial state to a subsequent state in which the first region does not have a higher concentration of charge carriers than the second region.

### Conduction layer materials

The conduction layer may comprise an oxide. For example, it may be formed from an oxide. Oxide layers are common within the field of semiconductor devices. As such, they can be created at relatively low cost and are easy to manufacture. If the first conduction layer comprises an oxide layer, this first conduction layer further comprises charge carriers.

There is a wide variety of oxides available for the oxide layer. This includes oxides which can be terminally grown. Such oxides may be deposited via thermal oxidation, chemical vapour deposition (CVD) or physical vapour deposition.

The conduction layer may comprise or be formed of one or more of the following: SiO₂, HfO₂, ZnO, CuO, NiO, MnO, Al₂O₃, ZrO₂ and TiO₂. Materials which are suitable for use as a gate oxide within Metal Oxide Semiconductor Field Effect Transistors (MOSFETs) may be used. The purpose of the oxide layer is to provide a dielectric layer.

In some examples, the conduction layer consists of a single oxide material. As such, the single oxide material may be present such that the charge carriers are provided with a path through the electric field which opposes the motion of the charge carriers. Such a configuration may be advantageous since it increases the ease with which the switch device may be manufactured. Within the semiconductor device setting complex geometries may be challenging to replicate in practice. Furthermore, without the presence of a second conduction material, the mobility of the charge carriers may be easier to predict. Precise control over the exact geometry and dimensions of the layers within the switch device may be enabled by the use of a single oxide material as consideration does not have to be given to the compatibility of a further conduction material with the first conduction layer. The charge carriers may therefore be present within a single oxide material and confined to a first region such that they are opposed in their motion to a second region due to the presence of the electric field by the presence of the first n-doped and first p-doped layers.

The use of only one oxide material within the conduction layer may allow for more predictability if the specifications of one material are well suited to a particular environment (i.e. the oxide does not degrade in the anticipated environment). Examples include, but are not limited to: SiO₂, HfO₂, ZnO, CuO, NiO, MnO, Al₂O₃, ZrO₂ and TiO.

The conduction layer may comprise tetraethyl orthosilicate (TEOS). Optionally, the conduction layer may consist of TEOS. TEOS is often used as a precursor to high purity semiconductors and conduction materials, therefore it is a relatively abundant material which can be obtained at low cost. Usually, TEOS is treated to remove charge carrier impurities as these affect the conductivity of a semiconductor device. The present invention uses the opposition of migration of charge carriers within the conduction layer. Such charge carriers, which are usually removed from TEOS can instead be used in an advantageous manner since they contribute to the operation of the device. Such a configuration means that the device is easier to manufacture as there is no longer a need for subsequent steps to reduce the concentration of charge carriers such as positive metal ions with a 1+ and 2+ charge.

The conduction layer may comprise a first sub-layer comprising at least a part of the first region; and a second sub-layer located adjacent the first sub-layer and extending from the first region to the second region. The use of a first and second sub-layer provides for greater flexibility of the structure of the switch device. This contributes to greater control over the path of the charge carriers through the structure. Furthermore, the charge carrier mobility within each structure can be more finely controlled by having two sub-layers. The first sub-layer may be at least partially located in the offset region.

The second sub-layer of the conduction layer may comprise the second region. This configuration may be advantageous since the two sub-layers of the conduction layer may be configured such that there is a higher concentration of charge carriers within the part of the first sub-layer which comprises at least a part of the first region and a lower concentration of charge carriers in the part of the second sub-layer which comprises the second sub-region. As such, the concentration gradient between these components can be more precisely controlled. For example, where a region of higher charge mobility is desirable, for example if the sub-layer extends between the n-doped layer and the substrate, this can be provided. In such an arrangement, the second sub-layer can be configured to conduct the charge carriers away from the first region to the second region more easily once the charge carriers have moved away from the first region. As such, when the charge carriers are provided with a voltage which allows for the charge carriers to move through the electric field which is configured to oppose their motion, the charge carriers may move from the first sub-layer layer to the second sub-layer layer. The use of two different materials may further allow for a barrier to be created such that there is resistance to the charge carriers moving from the first conduction layer to the second conduction layer. As such, the charge carriers are further retained within the first conduction layer which comprises at least a part of the first region.

The first and second sub-layers of the conduction layer may optionally comprise all of the first region and second region, respectively. The use of a first and second sub-layer layer provides further flexibility regarding the geometry of the switch device. The first and/or second sub-layer layers can be adjusted to be of sufficient thickness to provide a desirably electric field profile.

The concentration of charge carriers may be lower in the second conduction sub-layer as compared to the first conduction sub-layer. This may assist in determining the state of the switch device as it may be easier to tell whether or not the charge carriers have moved from a first position to a second position.

The first sub-layer may comprise tetraethyl orthosilicate (TEOS) and the second sub-layer may comprise an oxide, wherein the oxide is different to the oxide of the first sub-layer. Optionally, the first sub-layer consists of tetraethyl orthosilicate (TEOS) and the second sub-layer consists of an oxide, wherein the oxide is different to the oxide of the first sub-layer.

Such an arrangement makes use of the low cost of TEOS oxide, whilst providing flexibility regarding the material and therefore the charge carrier mobility in the second sub-layer. The use of a TEOS oxide layer and an oxide layer provides for an easy to assemble structure which is compatible with a large range of commonly used materials within semiconductor devices.

A portion of the conduction layer may extend between the first n-doped layer and the first p-doped layer to form a barrier therebetween.

### First and second regions

The first region is adjacent (i.e. abutting or next to but spaced from) the first p-doped layer meaning that the first region is proximal to, or near to the p-doped layer (i.e. nearer to the first p-doped layer than the first n-doped layer). This may be that the part of the conduction layer comprising first region abuts the first p-doped layer.

The second region is located between the first p-doped layer and the substrate (or, where present, a layer on the substrate forming a part of the first MOS).

The second region is adjacent the first n-doped layer meaning that the second region is proximal to, or near to the n-doped layer (i.e. nearer to the first n-doped layer than the first p-doped layer). This may be that the part of the conduction layer comprising second region abuts the first p-doped layer.

The second region is located between the first n-doped layer and the substrate (or, where present, a layer on the substrate forming a part of the second MOS). This is such that the (second) MOS comprising the first n-doped layer and the substrate (and, where present, the layer) is in an off state (or a pre-exposure) state. For example, the second region may extend across any boundary or interface (whether direct or indirect) between the first n-doped layer and the substrate (or, where present) layer. Then, when the charge carriers move into the second region, the second region enters a state in which the concentration of charge carriers increases. Interrogation across the second MOS accordingly gives a different reading and the second MOS is in a different state.

A part of the conduction layer defining at least a part of the first region is provided within the offset region.

By "initial state", it is meant a state in which the device is present. This does not preclude there being previous stages which enable the device to arrive at the "initial state", nor does it imply that subsequent states of the device cannot have a concentration of charge carriers being higher in the first region than the second region.

### Gate oxide

A gate oxide layer may be present as the first conduction layer, or as part of the first or second sub-layers of the conduction layer. A gate oxide may be deposited via thermal oxidation, chemical vapour deposition (CVD) or physical vapour deposition. Examples include, but are not limited to: one or more of the following: SiO₂, HfO₂, ZnO, CuO, NiO, MnO, Al₂O₃, ZrO₂ and TiO₂.

### Charge carriers

By charge carriers it is meant positively charged species which can carry an electrical charge. This may, include simple ions and compound ions. The conduction layer may comprise charge carriers selected from at least one of group I ions (H⁺, Na⁺, Li⁺, K⁺, Rb⁺ and Cs⁺), group II ions (Be²⁺, Mg²⁺, Ca²⁺, Sr²⁺ and Ba²⁺), group III ions (Al³⁺,Ga³⁺ and In³⁺) and transition metal ions (Cu²⁺, Zn²⁺, Pb²⁺, Fe²⁺, Fe³⁺ and Ag⁺). The conduction layer may comprise charge carriers selected from the group consisting of K⁺, Ca²⁺, Na⁺, Ni²⁺ and Cu²⁺, or combinations thereof. The amount of charge carriers is selected so that a change in the distribution within the conduction layer can be detected.

In the initial state, the surface concentration of charge carriers within the first region at the substrate/conduction layer interface may be at least 3.0 x 10¹¹ ions/cm², such as at least 5.0 x 10¹¹ ions/cm², such as 10.0 x 10¹¹ ions/cm², such as at least 20.0 x 10¹¹ ions/cm³.

In the initial state, the surface concentration of charge carriers within the second region at the substrate/conduction layer interface is less than or equal to 20.0 x 10¹¹ ions/cm², such as less than or equal to 10.0 x 10¹¹ ions/cm³, less than or equal to 5.0 x 10¹¹ ions/cm², lease than or equal to 3.0 x 10¹¹ ions/cm², or less than or equal to 2.0 x 10¹¹ ions/cm². In the second state, this may increase by at least 2 times, such as at least 3 times. In the second state, the surface concentration of charge carriers within the second region at the substrate/conduction layer interface may be at least 3.0 x 10¹¹ ions/cm², such as at least 5.0 x 10¹¹ ions/cm², such as 10.0 x 10¹¹ ions/cm², such as at least 20.0 x 10¹¹ ions/cm³, such as at least 27.0 x 10¹¹/cm².

In the initial state, the concentration in the first region is greater than the concentration in the second region. This may be a concentration difference of a factor of at least 2 times, such as at least 3 times.

The concentration of charge carriers within the conduction layer in the first region, in the initial state, may be at least 10²⁰, 10²², 10²⁵ or 10³⁰ charge carriers per m³.

### Substrate

By substrate, it is meant the base layer upon which the switch device is formed. It is desirable for the substrate to allow for growth and deposition of additional layers upon it such that layers grown are retained upon the substrate. Such substrates are commonly in the form of a wafer or sheet. The substrate may comprise Si, GaN, SiC and/or GaAs. These will allow it to form a semiconductor as part of the first MOSFET and second MOSFET.

The substrate may comprise or be formed of an undoped semiconductor. Where the substrate in the form of an undoped semiconductor is present, this will interact with the first p-doped layer as the first p-doped layer has a greater concentration of holes as compared to an undoped semiconductor. There will be a small movement of holes between the first p-doped layer and the semiconductor substrate. As such, the first p-doped layer will acquire a negative charge relative to the semiconductor substrate. Overall, therefore an electric field between the first p-doped layer and the undoped semiconductor will develop, wherein the electric field vectors are directed from the substrate and towards the first p-doped layer. This electric field will then cause positive charge carriers within the conduction layer to move towards the p-doped layer. The charge carriers can therefore be confined within the first conduction layer and are moved in a direction away from the semiconductor substrate due to the field between the semiconductor substrate and the p-doped layer.

The substrate may comprise an n-doped semiconductor. The substrate may comprise a semiconductor with a lower electron density than the first p-doped layer.

### Barrier Laver

The switch device may further comprise a diffusion barrier layer. Within the switch device, an electric field generated by the p-n junction opposes the migration of the charge carriers from the first region to the second region. This configuration allows for an electric field which restricts the movement of charge carriers within the switch device. There may, however, within the switch device, be alternative paths for the charge carriers to traverse. The presence of a diffusion barrier within the switch device may further help to confine the charge carriers and contribute to the charge carriers not diffusing or migrating through parts of the body of the switch device which may cause unpredictable behaviour. As such, a diffusion barrier has the property that it is able to prevent charge carriers from moving through it. The charge carriers being confined helps to prevent them from interfering with the electric field that is present within the switch device. Confinement of the charge carriers through a diffusion barrier may further improve the reliability of the switch device since there is a decreased likelihood that the charge carriers are able to move through the switch device without the conditions for the charge carriers to move through the electric field which opposes the motion of the charge carriers down a diffusion concentration gradient having been met.

The device may comprise a first diffusion barrier provided between the first p-doped layer and the first n-doped layer. This may be in any region where there are no other intervening layers, for example. In one configuration where one of the first n-doped layer or first p-doped layers extends above the other, the first barrier layer may be provided along the extent of the region between these two layers, irrespective of whether there are additional layers.

Additionally or alternatively, the first barrier layer or another barrier layer may be provided between the first p-doped layer and the first n-doped layer between the opposing vertical faces. Connection of the first p-doped layer and the first n-doped layer can therefore be prevented. If there is a direct connection between one or more of the polysilicon n-doped layer and one or more of the polysilicon p-doped layer, this can lead to a voltage drain if a potential difference is applied to the switch device. This may lead to unpredictability. The presence of a diffusion barrier, for example a nitride layer, may provide for electrical separation of the p-doped and n-doped layers which allows the electric field opposing the charge carrier motion down a diffusion gradient to be maintained, even when a voltage is applied.

Additionally In some configurations, this may further form a barrier layer over the spacing between the first p-doped layer and first n-doped layer at the opposing vertical faces. This may accordingly prevent migration of the charge carriers through this spacing to other layers or components within the devices.

The switch device may further comprise a diffusion barrier layer (or a second diffusion barrier layer) between the conduction layer and the first p-doped layer. This may act as a barrier between the conduction layer and the first p-doped layer so that charge carriers are prevented from moving from the conduction layer through to another part of the switch device. This may also further assist with the confinement of the charge carriers. This may extend across the interface between the first p-doped layer and the conduction layer.

The barrier layer(s) set out herein may be configured to prevent positively charged charge carriers passing through. If the conduction layer comprises an oxide material, common ions which may be present include K⁺, Ca²⁺, Na⁺, Ni²⁺ and Cu²⁺. The diffusion barrier layer(s) may be configured to prevent such ions from diffusing through the barrier layer.

The or each diffusion barrier layer may comprise or consist of one or more of the following: cobalt, indium oxide, tungsten nitride, titanium, titanium nitride, tantalum and tantalum nitride. The diffusion barrier layer may comprise a nitride-containing dielectric material. It is believed that the use of a nitride based dielectric material is well suited to the role of a diffusion. Nitride-containing materials such as tungsten nitride, titanium nitride and tantalum nitride may be well suited to use in the switch device as they may be stable in a wide range of environments (e.g. temperature, acidity, pressure and humidity) and be resistant to mechanical wear and damage. Further, where used between the first n-doped layer and the first p-doped layer, this provides a barrier for electrical connection between these, reducing interference with the forming of a stable electric field.

### General Architecture

The switch device may comprise a drain connected to the substrate adjacent the first p-doped layer and a source connected to the substrate adjacent the first n-doped layer so as to form a dual-gate MOSFET structure with the first p-doped layer and first n-doped layer - and the conduction layer - functionally between the source and drain.

The first p-doped layer may be provided with a first gate contact for electrical connection. This can accordingly be used to provide a voltage input to the first gate - acting as a "write" by enabling the control of the electric field and, therefore, the migration of the charge carriers within the conduction layer. The first n-doped layer may be provided with a second gate contact.

The switch device may take the form of any suitable gate or MOSFET structure.

In one configuration, it can be configured as a floating gate structure. In such a configuration, the first n-doped layer (i.e. forming the second gate structure) may be electrically isolated. Instead, a further gate - in the form of a further doped polysilicon layer - can be provided above the first n-doped layer.

In another configuration, it can be configured as a driven gate structure. In such a configuration, the first n-doped layer (i.e. forming the second gate structure) can be provided with a second gate contact. This can be used to apply a voltage across the second gate structure and determine a read of the state of the switch device. The first p-doped layer may overlay the first n-doped layer in such a structure.

In another configuration, it can be configured as a shorted gate structure. In such a configuration, the first n-doped layer (i.e. forming the second gate structure) can be provided with a second gate contact which can be connected to the source.

### Sensor

The switch devices disclosed herein may be to switch state upon a change being made to an external environment. For example, this may be a thermal event causing the device to switch state. Transducers or other devices that convert physical signal into voltage may be provided as long as the transducer or signal converter is able to operate within the environment concerned. Accordingly, the switch devices may be provided with a transducer for causing the application of a voltage across the switch device (i.e. across the first gate structure) in response to an environmental event.

In an embodiment, a sensor may comprise at least one switch device according to any of the embodiments set out herein; and a voltage generation device operably connected to the switch device so as to apply a voltage to the switch device, wherein the switch device is configured such that the voltage applied above a threshold voltage allows charge carriers to migrate from the first region to the second region wherein the voltage generation device is configured such that a physical event of a first magnitude causes the generation of a voltage above the threshold voltage. In other words, the aforementioned sensor may comprise at least one switch device according to the present disclosure and further a voltage generation device operably connected to the switch device such that a voltage provided by the voltage generation device provides the switch device with a voltage which is able to cause the charge carriers to move from the first region to the second region. Specifically, the voltage generation device can be electrically connected to the first gate contact of the first p-doped layer so as to generate a voltage across the structure acting as a first gate structure and reduce or remove the electric field at the p/n junction. In this way, the charge carriers can move from the first region to the second region, and thus a voltage can be applied by the voltage generation device. The voltage may be applied to the MOS formed by the first p-doped layer and the substrate (or additional layer, where present) so as to turn off the electric field and permit movement of the charge carriers. Accordingly, the voltage generation device may act as a "write" input for the switch device.

The voltage generation device may be configured such that a physical event of a first magnitude causes the generation of a voltage above the threshold voltage across the electrical terminals. A physical event of a first magnitude, or a first condition, may result in a voltage output from the voltage generation device. The environmental dependence of a voltage generation device provides a means by which an environmental exposure can be tracked.

The voltage generation device may be configured to generate a voltage in response to a thermal event of a first magnitude. For example, within an autoclave cycle, a temperature of an environment in which the sensor is located being in the range of 120- 130 °C, may result in the voltage generation device generating a first voltage.

Further, the switch device disclosed is able to operate without the need for a dedicated power store which provides voltage independently of the environment in which the sensor is located. The use of a voltage source which is independent of the environment in which the sensor is located may involve the use of a battery and/or electrically connecting the sensor to an electrical terminal such as a mains power supply. This may be disadvantageous as when in an environment in which there is high temperature, high pressure and/or extreme conditions, electrical devices such as batteries and components requiring complex circuitry and wiring may break down. Instead, the switch device disclosed may comprise electrical terminals such that the application of a voltage above a threshold voltage across the terminals causes charge carriers to migrate from the first region to the second region.

Within the present disclosure, the function of the voltage generation device is to provide a voltage to the charge carriers. Where the voltage supply is in response to an environmental change, when an environmental change event has occurred, the charge carriers have a voltage supplied to them such that the charge carriers can overcome the electric field which opposes their migration from the first region to the second region.

The voltage generation may be configured such that it only generates a voltage in response to one of an increase or a decrease in a physical parameter. This may be achieved using a thermocouple or thermopile and a directional voltage component such as diode.

### Examples of voltage generation devices

The voltage generation device may be configured such that it comprises one or more of the following: a piezoelectric voltage generator, a thermoelectric effect (Seebeck effect) generator, an inductive generator (Faraday's law), Photoelectric effect generator, Electrochemical effect voltage generator, Triboelectric effect voltage generator, Hall effect voltage generator or and Pyroelectric effect voltage generator.

The voltage generation device may comprise a thermocouple or a thermopile voltage generator. Thermocouples utilise the thermoelectric effect (Seebeck effect) and may be in the form of a thermocouple, or a thermopile (i.e. two or more thermocouples in series). For example, if a thermocouple or thermopile voltage generation device is connected to a switch device which is disposed upon a component undergoing thermal change, wherein the temperature is raised from a first temperature to a second temperature, the thermocouple or thermopile will develop a voltage across it which will be proportional to the temperature across its two regions. The voltage generated can be adjusted by altering the materials which are being used within the thermocouple(s) and/or by adjusting the number of thermocouples in series. When thermocouples are present in series, the overall output voltage is the sum of the individual voltages of the thermocouples. The voltage generation device may therefore be configured such that when the temperature difference between the first and second regions reaches a threshold value, the threshold voltage is formed across the at least one switch device.

The use of a thermocouple has the advantage that different metals can be used within the thermocouple, and as such thermocouples which are well suited to the environment may be selected. The use of a thermocouple is well suited to monitoring chambers where there are predictable temperature changes. An example of this is an autoclave cycle which may be used for medical apparatus.

The present device facilitates the recording of data which can be neither erased nor manually altered. The switch device provides a physical representation of the environment in which the switch device has been exposed to, rather than a secondary measure, such as a record being kept, which is prone to error. This may be important in a medical application in which the number thermal cycles which a component has gone through is an important factor in determining whether a component should be used for subsequent medical procedures. If records are not kept properly then this may lead to a decrease in the quality of patient care and even preventable fracture of a component during a medical procedure.

The thermopile or thermocouple comprises a first region and a second region separated from the first region such that a temperature difference between a first and second region arises can form between the first and second regions. Optionally a thermal barrier is present between the first and second regions. For example, an inner part of the thermocouple may be less exposed to a temperature change than an outer part of the thermocouple. As such, the heating and/or cooling rate within the regions of the thermopile may vary such that a voltage is developed across the thermocouple. The thermocouple or thermopile may therefore comprise a first material defining a first region and a second material defining a second region. The thermocouple or thermopile may be configured such that the temperature difference between a first and second region arises due to the first region being configured to heat and/or cool at a different rate to the second region. The advantage of this configuration is that there may not be the need to hold the first and second regions at a first location receiving the temperature change and a second location wherein the temperature change is different. By altering the thermal conductivity of each junction, the rate of temperature change and therefore the temperature-time profile in response to a given temperature change may be controlled. This may be advantageous, for example within the context of a pre-programmed and predictable temperature change, for example within an autoclave cycle. If a thermocouple or thermopile undergoes one autoclave temperature cycle, the voltage generated by the thermocouple due to the different heating and/or cooling rates of the first and second region can be configured such that the voltage reaches the threshold voltage required for the charge carriers to overcome the electric field and migrate from the first region to the second region.

The thermocouple or thermopile may be of type J, K T, E or N. Type K may be advantageous as they are usable over a wide temperature range including 200°C up to 1200 °C. These thermocouples can comprise Nickel-Chromium and/or Nickel-Alumel.

Though the example of an autoclave cycle has been discussed, such principles may readily be applied within the context of alternative thermal changes within systems that the switch device may be present within.

The layers and the p-n junction of the present switch device are configured to oppose the migration of the charge carriers from the first region to the second region, such that the behaviour of the present switch device throughout a broad range of conditions is predictable.. As such, rather than using a dedicated power store to enable retention of information relating to the state of the sensor, information relating to the state and/or changes thereof are encoded in the sensor itself. This reduces requirements for complex circuitry and therefore the likelihood of non-linear or unpredictable behaviour of components in different conditions. This is particularly advantageous within environments in which there are high temperatures (e.g. ≥100°C), low temperatures (e.g. ≤0 °C) high pressure (e.g. absolute pressure exceeding 150 kPa), high levels of acidity (e.g. pH ≤ 4), high levels of alkalinity (e.g. pH ≥ 10), radiation levels above background levels of radiation and/or magnetic fields above background levels. For example, within an autoclave cycle, typical temperatures are approximately 120-130 °C for between 0.5-2 hours at an absolute pressure of approximately 150-200 kPa which is applied from saturated steam. Such cycles are performed upon surgical equipment before surgery to sterilise the equipment. Though effective at killing bacteria and destroying viruses, components which undergo such a cycle may degrade over time, especially following multiple independent autoclaving events. The present switch device may provide the advantage of being able to track an event and store such data within a piece of equipment itself, rather than relying on external records or sensors requiring constant power. Within a medical context, the breakdown of surgical equipment may pose unnecessary risks to patients and lead to a decrease in the overall quality of care. As such, proper monitoring of the condition of surgical equipment may be beneficial through the use of the switch device(s) and/or sensors disclosed, which do not degrade upon the application of an autoclave cycle. The switch device and sensor disclosed within the present specification may be attached to or embedded within a component to be measured. A component to be measured may be a piece of medical apparatus such as a piece of surgical equipment.

The voltage generation device may comprise a piezoelectric voltage generator. Piezoelectric voltage generators utilise the piezoelectric effect (i.e. comprise a piezoelectric material), wherein the application of mechanical stress leads to the generation of a voltage. Such a voltage generator may, be used within the context of an accelerometer, a pressure sensor and/or a vibration sensor. A piezoelectric voltage generation device may allow sensing of whether vibrations reach a certain threshold (e.g. for the monitoring of sound levels, and earthquakes).

As set out above, the voltage generation device may comprise an inductive generator configured to output a voltage in response to a change in magnetic field, which may be due to motion. This may rely on Faraday's law. This may, for example, be used to detect whether a given change in the magnetic flux has occurred. This may be used to detect movement by placing the inductive generator in a magnetic field. This may further be used within a context of medical imaging utilising an MRI. The voltage generation device may be a photoelectric effect generator. This may, for example be used to detect whether the illumination incident upon a switch device has reached a given wavelength or intensity threshold. This may be useful for monitoring light levels in dark environments. The voltage generation device may be an electrochemical effect voltage generator. As such, the switch device may be used within a breathalyser setup to measure pH levels and/or other concentrations of chemicals. Further examples of voltage generation devices include a triboelectric effect voltage generator which may optionally be used to measure relative motion between two surfaces. The voltage generation device may be a hall effect voltage generator to optionally monitor changing magnetic fields within a system. The voltage generation device may be a pyroelectric effect voltage generator to optionally monitor the thermal cycles within a system for example. These voltage generation devices may be utilised to supply the charge carriers with a voltage, dependent upon the environment in which the voltage generation device is located.

### Switch device arrangements

The sensor may comprise a plurality of switch devices. In one embodiment, the sensor comprises a plurality of switch devices according any of the embodiments disclosed herein, wherein each of the switch devices is connected in series forming a switch device set and wherein the voltage generation device is operably connected to each switch device of the switch device set. The switch devices may be configured such that each switch device is individually actuatable (i.e. moves from the initial state to the second state) per one single event. In this way, each can act as a sensor capable of detecting multiple events.

The switch devices may be connected such that the source of one switch device is connected to the first gate structure (i.e. the first p-doped layer) of the next in the series. These together are connected to the voltage generation device. Once an environmental event above the threshold has occurred and the voltage has been applied across a first switch device, which effectively switches off the electric field and allows the diffusion to occur in the first switching device, this first switching device is permanently on (i.e. once the first switch device has been actuated by the application of the threshold voltage). This first switching device then effectively acts as a resistor as the channel has been inverted and is permanently on, so that a subsequent voltage can affect the subsequent switch device in series. A subsequent application of a voltage will then lead to application of the voltage to the next switch device in series. As such, the switch devices may be configured such that they each detect one in a sequence of environmental (i.e. physical) events. For example, a temperature rise may cause a voltage to be developed across a thermocouple.

A user can then determine how many individual switching devices are "on" (i.e. have the channel completed) in the series.

Where there is a plurality of switch devices, each switch device may determine the occurrence of the same type of event. For example, an event may reoccur periodically, and the switch devices may be used to determine the number of counts of the reoccurring event. In some embodiments, there may be different sets for determining different events. This may depend on the configuration of the switch devices or the voltage generation device. For example, the voltage generation device may be configured to generate a first voltage in response to a first change in temperature from a first temperature to a second temperature, the first change being of a first magnitude sufficient to generate a voltage above the threshold voltage; and further configured to generate a second voltage in response to a second change in temperature from the second temperature to the first temperature, the second change being of a second magnitude sufficient to generate a voltage above the threshold voltage. The first and second voltages may be, in some cases, a voltage of opposite polarity (but of magnitude above the threshold voltage) or it may be a second application of a voltage of the same polarity. A thermocouple or thermopile may achieve this by generating a voltage as a temperature rises and a second voltage (of opposite polarity) when the temperature falls. This may trigger a first switch device in a series as the temperature rises and then the second switch device in a series as the temperature falls, providing confirmation that an event has occurred. For example, the rise and fall of an autoclave cycle may be detected for a component that has undergone several autoclave cycles. The first sensor set and second sensor set may each comprise 5, 10, 15 or 20 or more switch devices in series.

### Switch device sets sensors in parallel

A plurality of independent switch device sets may be used within the sensor such that each independent switch device set is configured to indicate information about a physical parameter. For example, a first independent switch device set may be dedicated to temperature, whereas a second independent switch device set may be dedicated to pressure. Alternatively, two or more sets may be used for detecting the same physical parameter so that there is additional verification regarding the environment that the sensor has been subjected to.

### Measurements of the sensor and detectors

A system may comprise the switch device and/or sensor according to any of the embodiments disclosed herein and, further, a reader configured to determine the state of the or each switch device. This can specifically interrogate whether the concentration of charge carriers in the second region has increased, for example by applying a voltage across the second gate structure (i.e. the first n-doped layer and substrate MOSFET).

The reader can measure the electrical property. That is, a reader unit is provided that may apply a stimulus to determine the electrical property of the switch device. The reader converts the measured electrical property into a signal. For example, the reader may extract an analog measurement of the electrical property and convert the analog measurement to a digital signal for further processing. The communication interface then transmits this signal to a host controller, which may be an external controller for processing of the signal to determine the cumulative count of events, and to perform further analysis. In other words, the communication interface provides the signal from the reader to the host controller via a wired or wireless connection.

The system may include a processing unit configured to determine whether the or each switch device has changed from the initial state. This may be a part of the reader. That is, the processing of the read out from the switch device to provide the event data, and potentially the component data and identification of faults, may be performed locally to the reader and communication interface, or may be performed on another device. Or both, as a combination or an additional redundancy. By performing this locally, a fully integrated system may be provided. On the other hand, extensive computational resources may be available to the host processor in the form of cloud computing or other processing centres which may facilitate more complex analysis of the signal.

In addition, the system may further comprise a memory unit configured to store the determined event data. Where event data is present, the system may further comprise a memory unit configured to store the determined thermal cycle data. Where event data is present, the system may further comprise a memory unit configured to store the determined event exposure event data. The memory unit may provide storage of the event data that may ensure that the data is readily available when requested, rather than when the system produces such data.

In one example, a switch device within a sensor may be turned to an "on" position such that charge carriers are able to flow through it once the surface charge density reaches a first value. In an example, the first value is approximately 3x10¹¹ C cm⁻², however, if greater certainty regarding whether the gate is on or not is desired, a higher threshold may be used, for example approximately 0.8-1.2x10¹² C cm⁻².

### Methods

According to the invention, there is provided a method of determining whether a physical event of a first magnitude has occurred, the method comprising: providing a sensor according to any of the embodiments disclosed herein; exposing the sensor to an environment in which a first physical event may occur such that a voltage at or above the threshold voltage is produced by the voltage generation device; and interrogating the sensor to determine whether the first physical event occurred.

In an embodiment, there may be provided a computer program comprising computer program code which is configured, when said computer program is run on one or more physical computing devices, to cause said one or more physical computing devices to implement the methods disclosed herein. In particular, the steps of interrogating the sensor to determine whether the first physical event occurred.

In another embodiment, there may be provided one or more non-transitory computer readable media having a computer program stored thereon, the computer program comprising computer program code which is configured, when said computer program is run on one or more physical computing devices, to cause said one or more physical computing devices to implement the methods disclosed herein. In particular, interrogating the sensor to determine whether the first physical event occurred.

According to the invention, there is provided a method of manufacturing a switch device, the method comprising: providing a substrate; depositing a conduction layer on the substrate, wherein the conduction layer extends from a first region adjacent the first p-doped layer to a second region adjacent the first n-doped layer, wherein the conduction layer comprises a plurality of charge carriers moveable within the conduction layer and wherein, in an initial state, the concentration of charge carriers in the first region is higher than in the second region; and forming a p-n junction by depositing a first p-doped layer on the substrate adjacent the first region and depositing a first n-doped layer on the substrate adjacent the second region and such that first n-doped layer opposes the first p-doped layer. The first p-doped layer is vertically offset relative to the first n-doped layer to provide an offset region adjacent the first p-doped layer in which a plane parallel to the surface of the substrate extends through the offset region and the first n-doped layer. A part of the conduction layer defining at least a part of the first region is provided in the offset region such that an electric field generated by the p-n junction opposes the migration of the charge carriers from the first region to the second region.

### Specific Implementations

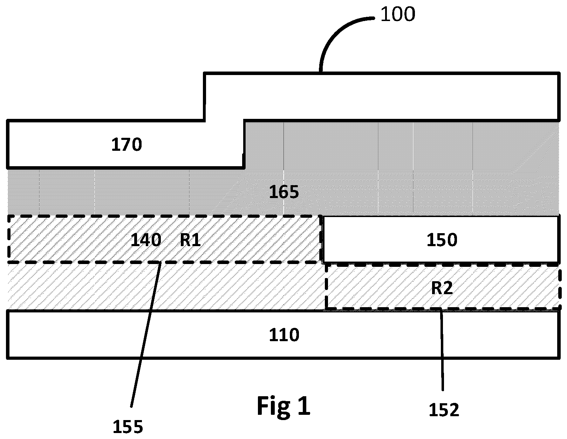

Fig. 1 schematically depicts a cross-section through a switch device 100, which can be used to record information relating to a physical event. This physical event may, for example, be a temperature change, for example.

The switch device 100 comprises a substrate 110 forming a base and which is a planar layer.

The switch device 100 further comprises a conduction layer 140 which is disposed upon the substrate 110 and extends across the extent of the substrate 110. The conduction layer 140 is an oxide material through which charge carriers can moved. The conduction layer 140 in this embodiment has a stepped structure, with a raised portion and a lower portion, as discussed in more detail below.

The switch device 100 further comprises a p-n junction. The p-n junction is formed of a first n-doped layer 150 provided on the substrate 110 and a first p-doped layer 170 provided on the substrate 110. The first n-doped layer 150 is provided directly on the conduction layer 140 on the lower portion and, in this embodiment, opposes the raised portion of the conduction layer. The first p-doped layer 170 is vertically offset relative to the first n-doped layer 150 to provide an offset region 155 adjacent the first p-doped layer 170 in which a plane parallel to the surface of the substrate 110 extends through the offset region and the first n-doped layer 150.

The conduction layer extends from the raised portion which defines a first region R1 adjacent the first p-doped layer 170 (in this example, it is substantially the same as the offset region 155 and delimited by the same dashed lines as the offset region 155) to a second region R2 (delimited by dashed lines labelled 152) on the opposite side of the substrate 110 adjacent the first n-doped layer 150. The conduction layer 140 comprises a plurality of charge carriers moveable within the conduction layer and wherein, in an initial state, the concentration of charge carriers in the first region R1 is higher than in the second region R2.

A part of the conduction layer 140 defining at least a part of the first region R1 is provided in the offset region 155 such that an electric field generated by the p-n junction (i.e. first p-doped layer 170 and the first n-doped layer 150) opposes the migration of the charge carriers from the first region R1 to the second region R2.

In this embodiment, the switch device 100 further comprises a diffusion barrier layer 165 which is configured to prevent the movement of the plurality of charge carriers through the switch device 100. As such, the charge carriers are held in the first region R1 and can only migrate through the device by moving to the second region R2.

The switch device 100 accordingly provides a dual-gate MOSFET structure in which the there is a first FET or gate structure comprising the first p-doped layer 170 and the substrate 110 and a second FET or gate structure comprising the first n-doped layer 150 and the substrate 110. The conduction layer 140 provided between the first p-doped layer 170 and the substrate 110 and, similarly, between the first n-doped layer 150 and the substrate 110 and extending therebetween provides a gate oxide in which a channel can be formed once the charge carriers have diffused from the first region R1 to the second region R2.

Although not depicted, a source and drain may be provided to the substrate 110, with the source on the second region R2 side of the switch device 100 and the drain on the first region R1 side of the switch device 100. A first gate contact (not shown) may contact the first p-doped layer 170 and a second gate contact (not shown) may contact the first n-doped layer 150.

In an initial state of the switch device 100, the first region R1 comprises a higher concentration of charge carriers. The charge carriers will seek to move through the conduction layer 140 from the higher concentration first region R1 to the lower concentration second region R2 but are prevented from doing so by an electric field acting in opposition- i.e. acting as an electrostatic barrier.

When a threshold voltage is applied to the switching device 100, and specifically to the first gate or FET structure, it reduces or eliminates the electric field between the first n-doped layer 150 and first p-doped layer 170 within the switching device 100 and allows the charge carriers to move from the first region R1 to the second region R2. Specifically, the application of the voltage charges the gate of one MOSFET (e.g. the first gate) to the threshold voltage, which reduces or turns off the electric field. This converts the switch device 100 to a second state.

In this second state, the concentration of charge carriers in the second region R2 is increased, meaning that the second gate or MOSFET structure will now provide a different response because of the presence of charge carriers in the second region R2 of the conduction layer 140 between the first n-doped layer 150 and the substrate 110. This turning of the second gate or MOSFET structure enables a user to determine the state of the switch device 100. The switch device 100 can therefore be interrogated (e.g. through the application of a voltage) to the second gate (i.e. the comprising first n-doped layer 150) to determine whether the charge carriers are in the second region or not.

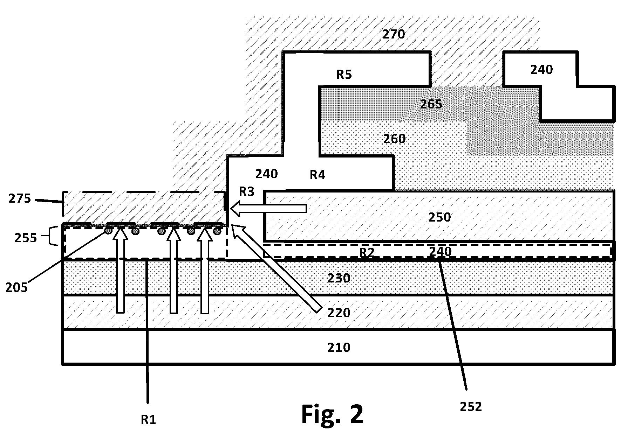

Fig. 2 schematically depicts a second switch device 200 according to the disclosure.

The switch device 200 comprises a substrate 210 forming a base and which is a planar layer. The switch device 200 in this embodiment further comprises a polysilicon n-doped layer 220 disposed directly on the substrate 110 and extending across the substrate 110.

Above the polysilicon n-doped layer 220, a gate oxide layer 230 is provided which is disposed directly on the polysilicon n-doped layer 220.

Above the gate oxide layer 230 is provided a conduction layer 240, which in this embodiment is a TEOS oxide layer. The conduction layer 240 is provided with a first part comprising first to fifth regions R1-R5, which will be discussed in more detail below, and a second part disconnected from the first part. The second part of the conduction layer 240 does not contribute to the functionality of the switch device and instead is present as of manufacturing.

The conduction layer 240 provides a material through which charge carriers can move from a first region R1 of the conduction layer 240 located on the left side of the switch device 200 as shown in Fig. 2 to a second region R2 (denoted by dashed lines 252) provided on the right side of the switch device 200 as shown in Fig. 2. Positive charge carriers 205 are shown in the conduction layers 240. These charge carriers 205 are able to move through the conduction layer 240 and may further move through the gate oxide layer 230 when moving from the first region R1 to the second region R2. For completeness, we note that the switch device 200 may be considered to comprise a single conduction layer which itself may be considered to comprise two sub-layers, the first sub-layer being the conduction layer 240 and the second sub-layer being the gate oxide layer 230, since the charges can move within these layers.

The switch device 200 further comprises a p-n junction. The p-n junction comprises a first n-doped layer 250 provided on the substrate 210 and a first p-doped layer 270 provided on the substrate 210. The first n-doped layer 250 is provided as a planar layer extending across the right hand side of the switch device 200 across the second region R2 of the conduction layer 240. The first p-doped layer 270 extends over the first region R1 of the conduction layer 240 and further extends to indirectly overlay the first n-doped layer 250.

The first p-doped layer 270 (for example, a SiGe-based p-doped polysilicon layer) is vertically offset relative to the first n-doped layer 250 to provide an offset region 255 adjacent the first p-doped layer 270 in which a plane parallel to the surface of the substrate 210 extends through the offset region 255 and the first n-doped layer 250. In this case specifically, the base of the first p-doped layer 270 is vertically offset from the base of the first n-doped layer 250. This creates a region in the plane of the base of the first n-doped layer 250 and above where there is no directly opposing first p-doped layer 270. Instead, in this embodiment, a portion of the conduction layer 240 extends into this offset region 255 so that a plane parallel to the substrate 210 extending through the first p-doped layer 270 extends through a part of the conduction layer 240, in this case the part defining the first high concentration first region R1.

Although the first p-doped layer 270 is vertically offset relative to the first n-doped layer 250, a part of the first p-doped layer 270 is vertically aligned with the first n-doped layer 250 such that a plane parallel to the substrate extending through the first n-doped layer 250 will pass through a part of the first p-doped layer 270 (in this case, defined by the middle to upper regions of the first n-doped layer 250). The region of the first p-doped layer 270 where this overlap occurs can be referred to as an overlap region 275.

The conduction layer 240 further extends vertically between the first p-doped layer 270 and first n-doped layer 250 between opposing, spaced apart vertical faces. This region of the conduction layer 240 is designated as a third region R3. A further portion extends horizontally over the top of a part of the first n-doped layer 250 to define a fourth region. Finally a fifth region R5 of the conduction layer 240 branches off vertically and then horizontally underneath the overlaying portion of the first p-doped layer 270, described in more detail below.

The first n-doped layer 250 is overlayed in the region not covered by the conduction layer 240 (the fourth region R4) by a nitride diffusion barrier layer 260 and further overlayed by an n-doped polysilicon layer 265. These are partially overlaid by the fifth region R5 of the conduction layer 240.

As noted above, the first p-doped layer 270 extends from the left hand side of the switch device 200 to indirectly overlay the first n-doped layer 250. Specifically, the first p-doped layer 270 is provided over the conduction layer 270 to extend to the n-doped polysilicon layer 265. These are insulated from the first n-doped layer 250 to prevent electrical shorting.

The nitride diffusion barrier layer 260 acts to prevent movement of the charge carriers 205 through the to the other parts of the switch device 200.

Arrows representing electric field vectors have been added to Fig. 2. Specifically, the arrows indicate the electric field vectors between the first n-doped layer 250 and the first p-doped layer 270 and the field vectors between the polysilicon n-doped layer 220 and the first p-doped layer 270.

The switch device 200 is used in a similar manner to the switch device 200 of Fig. 1, in that, in the initial state, the charge carriers 205 are provided in the first region R1 of the device

As shown in the Fig. 1, an electric field is generated between the polysilicon n-doped layer 220 and the first p-doped layer 270. These electric field vectors are vertical through first region R1 of the conduction layer 240. The effect of this is that positive charge carriers 205 are biased towards the first p-doped layer 270. This causes a build-up of charge carriers within the first region R1 adjacent the interface with the first p-doped layer 270.

In the initial state, movement from the first region R1 and the second region R2 is opposed primarily by the substantially horizontal electric field (represented by the horizontal arrow) from the first n-doped layer 250 to the first p-doped layer 270 to confine the charge carriers within the first region R1. Further, the charge carriers 205 are also, at least in part, prevented from passing into the fourth region R4 through the third region R3 because of this electric field. However, should they reach the fourth region R4, the charge carriers 205 will be prevented from diffusing through the switch device 200 by the nitride diffusion barrier 260. If the charge carriers reach the fifth region R5, they are also prevented from diffusing through the structure by the first p-doped layer 270 and the second polysilicon layer 265. As such, the charge carriers 205 are only able to move through the structure if they pass under the first n-doped layer 250 into the second region R2.

In this embodiment, in addition to the horizontal electric field provided between the first n-doped layer 250 to the first p-doped layer 270, there may also be a diagonal electric filed provided between the polysilicon n-doped layer 220 and the first p-doped layer 270. The vertical offset between the first n-doped layer 250 and the first p-doped layer 270 means that there is a horizonal and a diagonal electric field created between the first n-doped layer 250 and the first p-doped layer 270, further resisting movement of the charge carriers 205.

Once a voltage is applied across the first gate formed by the first p-doped layer 270 and the substrate 210, this can effectively neutralise the electric field. At this point, the charge carriers 205 are free to move form the first region R1 to the second region R2, in the same manner as for the switch device 100 of Fig. 1.

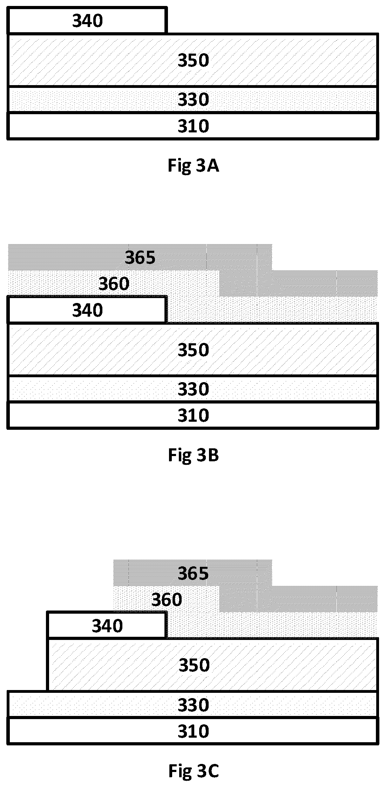

A further embodiment of a switch device may be fabricated according to the stages illustrated in Figs. 3A-3F and described below.

Within this embodiment, a silicon substrate 310 is used. A gate oxide 330 is then then grown upon the silicon substrate 310. A first n-doped polysilicon layer 350 is then deposited upon this gate oxide 330. A TEOS oxide layer 340 is then applied to this first n-doped polysilicon layer 350. The resulting structure from bottom to top is: a silicon substrate 310, a gate oxide 330, a first polysilicon n-doped layer 350 and a TEOS oxide layer 340. The silicon substrate 310 allows the growth of the gate oxide 330 and subsequent layers upon it. Silicon is a suitable material for this function as it is relatively low cost and can withstand a range of thermal environments without degrading. Furthermore, a silicon substrate 310 provides mechanical stability for the structure. The gate oxide 330 facilitates a limited movement of electrons through it and further forms part of the conduction layer which allows a plurality of charge carriers to move through it. The deposition and growth of the various layers within the switch device structure such as the gate oxide 330, TEOS oxide layer 340, n-doped and p-doped polysilicon layer(s) and the nitride layer(s) may be facilitated through conventional techniques such as physical vapour deposition, molecular beam epitaxy and chemical vapour deposition.

The TEOS oxide layer 340 is then masked and an etch is performed such that part of the TEOS oxide layer 340 is removed. This results in the structure labelled in Fig. 3A. A nitride layer 360 is then applied to the surface followed by a second polysilicon n-doped layer 365. This results in the structure of Fig 3B. TEOS oxides are often used a precursor for the formation of high purity silicon semiconductors. TEOS oxides often contain group 1 and group 2 ions throughout their structure. These ions can decrease the predictability of silicon semiconductors; therefore, their presence is often to the detriment of silicon semiconductors. As such, it is common within the field of silicon semiconductor manufacturing for there to be several processing stages of the TEOS oxide layer before it is usable. This can be costly both financially and in terms of the energy expenditure. One of the advantages of the example structures presented is they do not require such processing stages to remove the ions present within the TEOS oxide layer. Instead, such ions may be used as charge carriers such that the positive ions within the TEOS oxide layer move through into the gate oxide layer 330 and move through the switch device structure when they are supplied with sufficient voltage. The masking and etching of the TEOS oxide layer 340 may be achieved through selective etching. The purpose of this stage is to create a structure, wherein the TEOS oxide layer 340 does not extend through the structure and instead only partially covers the layer. As such, the charge carriers must migrate into the gate oxide layer 330 (of the final structure) in order to move through the switch device. Within the structure, the first sub-layer of the conduction layer may be the TEOS layer, and the second sub-layer of the conduction layer may be the gate oxide layer. The movement of charge carriers from the TEOS oxide layer 340 into the gate oxide layer 330 and being opposed by the electric field generated within the structure provides for adjustability when manufacturing. Without being bound by theory, it is believed that causing the plurality of charge carriers to move from a first material (TEOS oxide) to a second material (gate oxide) provides a further barrier to their movement through the switch device which further contributes to the reliability and predictability of the movement of the charge carriers. As such, it may be possible for an operator to determine with a greater certainty whether the conditions required for the migration of the plurality of charge carriers from the first region to the second region have occurred. This increased reliability may be due to the additional confinement of the charge carriers caused by their need to move between materials.

A portion of the second polysilicon n-doped layer 365 is patterned and the second polysilicon n-doped layer 365 is then used as an etch for the nitride layer 360. A portion of the second polysilicon n-doped layer 365 and a corresponding portion of the nitride layer 360 below the second polysilicon n-doped layer 365 is therefore removed. Within the structure, the nitride layer 360 has been utilised as this provides a suitable diffusion barrier for the charge carriers which are initially present within the TEOS oxide. Nitride layers can easily be manipulated and grown which may be advantageous for such applications. If there is a connection between the first or second polysilicon n-doped layer and the first polysilicon p-doped layer, upon application of a potential difference to the TEOS oxide layer, there will be a flow of charge between the first or second polysilicon n-doped layer and the first polysilicon p-doped layer which will lead to a voltage drain within the switch device.

Within the structure, more generally, it is desirable that the charge carriers can only move through the structure by moving through the electric field which acts in opposition to their migration. If alternative pathways are present, this may be problematic as the charge carriers may be able to freely move throughout the structure without being impeded or opposed by the presence of the electric field.

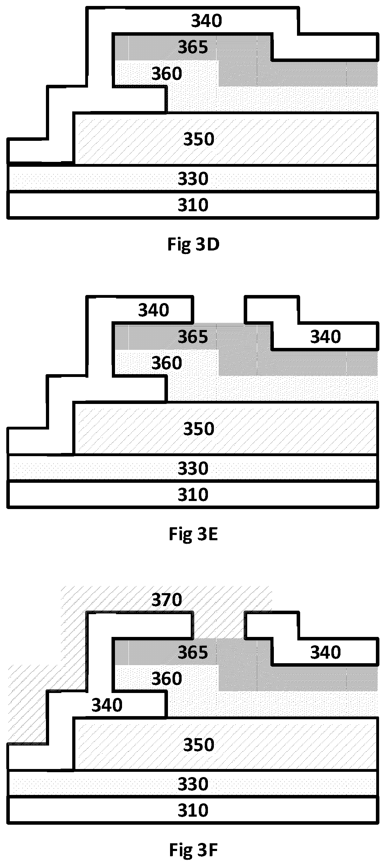

Part of the TEOS oxide layer 340 and first n-doped layer 350 are then removed together resulting in the structure of Fig. 3C. A TEOS oxide layer 340 is then applied to the structure resulting in the structure of Fig. 3D.

Part of the uppermost TEOS oxide layer is then removed as shown in Fig. 3E. A first layer of p-doped polysilicon 370 is applied to the surface. The first p-doped layer 370 is a p-doped material, which may optionally comprise SiGe. This results in the structure of Fig. 3F. The removal of part of the TEOS oxide layer 340 before application of the first layer of p-doped polysilicon 370 breaks up the flow path of the charge carriers within the TEOS oxide layer 340. As such, the charge carriers within the switch device can only move through the switch device by moving provided by the p-n junction. By filling in the gap with the first layer of polysilicon p-doped material, this effect can be achieved in a predictable manner

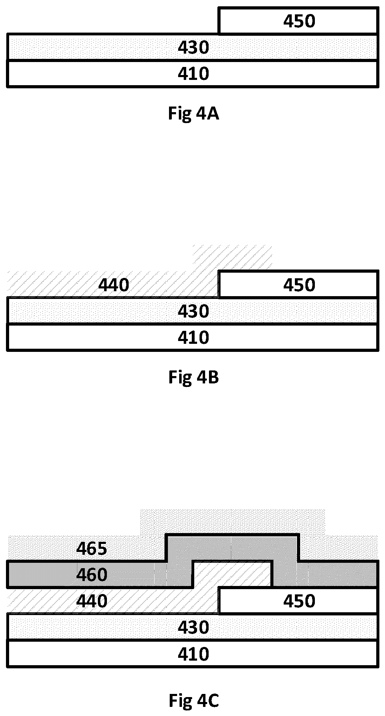

A further embodiment of a switch device may be fabricated according to the stages illustrated in Figs. 4A-4F and described below.

A gate oxide 430 is deposited upon a silicon substrate 410 followed by a first polysilicon n-doped layer 450. The first polysilicon n-doped layer 450 is patterned such that part of it is removed. This leaves, from bottom to top, a silicon substrate 410, a gate oxide 430 and then a polysilicon layer 450 which has been partially removed. This structure is depicted in Fig. 4A.

A TEOS oxide layer 440 is then applied on top of the second polysilicon n-doped layer 465. A portion of the TEOS oxide layer 440 which overlaps the second polysilicon n-doped layer 465 is removed. This has the effect of opening up the TEOS oxide layer 440. The resulting structure is depicted in Fig. 4B.

A nitride layer 460 followed by a second polysilicon n-doped layer 465 is then applied to the surface of the device. The resulting structure is shown in Fig. 4C.

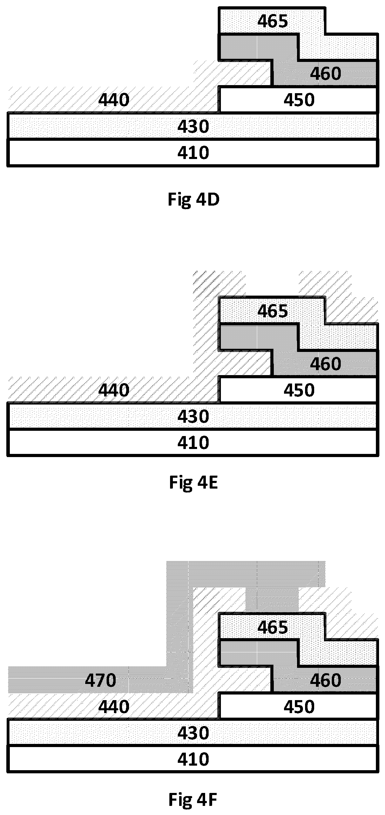

Part of the second polysilicon layer 465 which overlays the TEOS oxide layer 440 is then patterned to remove it. Following this, part of the nitride layer 460 which overlays the TEOS oxide layer is then removed. The resulting structure is shown in Fig. 4D.

A further TEOS oxide layer is then applied and then partially removed to create a discontinuity within this TEOS oxide layer. The purpose of this discontinuity is to prevent charge carriers from moving through the uppermost TEOS oxide layer from one side to the other. This results in the structure of Fig. 4E.

A first p-doped layer 470 is then applied to the surface. The first p-doped polysilicon layer 470 fills the gap left by the partially removed TEOS oxide layer 440 and covers the remaining TEOS oxide layer. Part of the first polysilicon p-doped layer 470 is then removed. The final structure is shown in Fig. 4F. The first polysilicon p-doped layer 470 which fills in the gap left by the partially removed TEOS oxide layer 440 provides a diffusion barrier for charge carriers within the TEOS oxide layer 440.

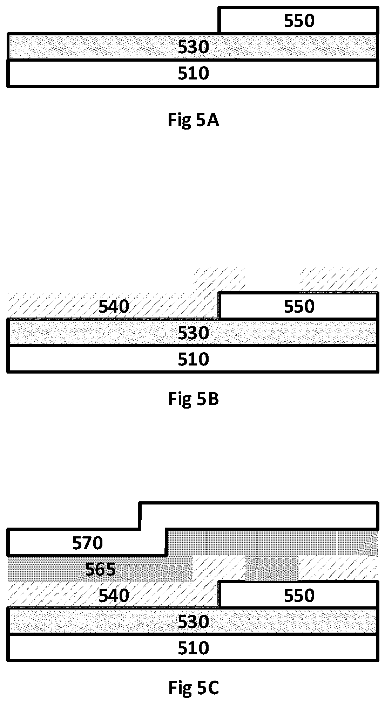

A further embodiment of a switch device may be fabricated according to the stages illustrated in Figs. 5A-5F and described below.

The structure starts off with a silicon substrate 510, upon which a gate oxide layer 530 and then a first polysilicon n-doped layer 550 are deposited upon it. Part of the first polysilicon n-doped layer 550 is patterned to remove it resulting in the structure of Fig. 5A.

A TEOS oxide layer 540 is then applied to the surface. Part of the TEOS oxide layer 540 which overlaps the first polysilicon n-doped layer 550 is then partially removed resulting in an opening. This results in the structure of Fig. 5B.

A nitride layer 565 followed by a first p-doped polysilicon layer 570 are then applied to the surface resulting in the structure of Fig. 5C.

An intermediary stage before the final stage may involve increasing the opening width of the TEOS oxide layer 540. This may be achieved by first patterning the uppermost polysilicon p-doped layer - i.e. first p-doped layer 570 - to remove part of it. This may be followed by the subsequent removal of part of the nitride layer 565 and the TEOS oxide layer 540 below it. This results in a wider opening within the TEOS oxide layer 540 as compared to the opening which was present in Fig. 5B. The nitride layer 565 and polysilicon layer 570 may then be re-applied to the surface resulting in the structure of Fig. 5C, but with a wider opening. The function of this final stage is to increase the ability of the nitride layer 565 to act as a diffusion barrier to charge carriers which are present within the TEOS oxide layer 540. By preventing the charge carriers from moving through the structure using the nitride layer 565, the charge carriers can only travel through the switch device if they move through the gate oxide layer 530.

The stages shown in Figs. 4A-4F and Figs. 5A-5C represent a simplified sequence for producing a structure which is similar to that which is produced by the stages represented in Fig. 3A-3F.

Within all of the final structures, represented by Fig. 3F, 4F and 5C, a p-n junction is provided which opposes the migration of charge carriers from a first region to a second region. Within these structures, the first region is represented by part of the TEOS oxide layer 340; 440; 540 which is proximal to the first p-doped layer 370; 470; 570. The second region is represented by part of the gate oxide layer 330; 430; 530 which is proximal to the first n-doped layer 350; 450; 550. Within these structures, the conduction layer is divided into two-sublayers, wherein the first sub-layer is the TEOS oxide layer 340; 440; 540 and the second sub-layer is the gate oxide layer 330; 430; 530.

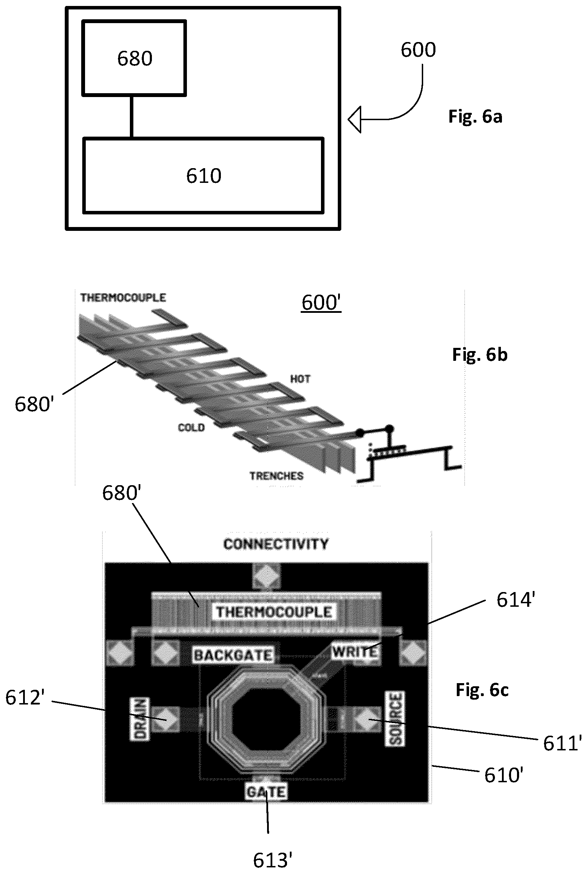

Fig. 6A schematically depicts a top-view of a sensor 600 comprising a switch device 610 according to the present disclosure, and which may take the form of any of the switch devices of Figs. 1 to 5C. The sensor 600 also comprises a voltage generation device 680 operably connected to the switch device 610. In particular, the voltage generation device 680 is operably connected to the switch device 610 so that it can apply a voltage to the switch device 610. This will usually involve electrical connection to the components forming the first gate structure around the first region R1 of the switch device 610.

The voltage generation device 680 is configured such that when the environmental event occurs (e.g. an event having a magnitude at or above a first magnitude), the voltage generation device 680 generates a voltage at or above a threshold voltage, which is provided across the switch 610 and, in particular, can be across the first gate structure. This eliminates or decreases the intensity of the electric field at the p-n junction which removes, or at least reduces, the opposition to migration of the carrier charges from the first region R1 to the second region R2.

Accordingly, in this way, the voltage generation device 680 is configured such that a physical event of a first magnitude causes the generation of a voltage above the threshold voltage so that the switch device 610 can be actuated.

In a modified version of the sensor 600, there may be a plurality of switch devices 610. These may each be connected to the voltage generation device 680 and arranged in series with one another. The switch devices 610 are arranged configured such that each switch device 610 is individually actuatable (i.e. moves from the initial state to the second state) per one single event. **In** this way, the sensor 600 is capable of detecting multiple events.

The switch devices 610 may be connected such that the source of one switch device 610 is connected to the first gate structure (i.e. the first p-doped layer) of the next in the series. These together are connected to the voltage generation device 680. Once an environmental event above the threshold has occurred and the voltage has been applied across a first switch device 610, which effectively switches off the electric field and allows the diffusion to occur in the first switch device 610, this first switching device 610 is permanently on (i.e. once the first switch device 610 has been actuated by the application of the threshold voltage). This first switch device 610 then effectively acts as a resistor as the channel has been inverted and is permanently on, so that a subsequent voltage can affect the subsequent switch device 610 in series. A subsequent application of a voltage will then lead to application of the voltage to the next switch device in series. As such, the switch devices 610 may be configured such that they each detect one in a sequence of environmental (i.e. physical) events. For example, a temperature rise may cause a voltage to be developed across a thermocouple.

This can be useful in temperature cycles. For example, within an autoclave cycle, typical temperatures are approximately 120-130°C for between 0.5-2 hours. If the sensor 600 is used within an autoclave cycle, the voltage generation device 680 may be configured to generate a voltage in response to the cycle. This voltage may be greater than or equal to the threshold voltage required for a plurality of the charge carriers in the switch device 610 to move from the first region to the second region. Each time a heating cycle occurs above the temperature threshold, one switch device 610 will be actuated providing a count of the number of events.

Fig. 6B depicts a sensor 600' which has the structure of sensor 600 of Fig. 6A and which may include one or more switch devices 610' which can be the same as the switch device of any of the embodiments disclosed herein.

The sensor 600' comprises a voltage generation device 680' operably connected to the switch device 610'. In this example, the voltage generation device 680' is a thermocouple. The thermocouple has a standard thermocouple structure in that a temperature differential across the thermocouple will generate an electromotive force such that a voltage can be output. The thermocouple is operably connected to the switch device 610' so that it can apply a voltage to the switch device 610' (in particular, across the first gate structure around the first region of the switch device 610' so as to eliminate the electric field). The thermocouple can be designed so that the voltage threshold sufficient to allow movement of charge carriers from the first region to the second region will only occur at a set temperature. The thermocouple can accordingly be arranged on or within a component and monitor any temperature changes of a particular magnitude the component is exposed to.

Where such an arrangement is used with a plurality of switch devices 610' arranged in series, this can be configured such that an increase in temperature will output a first voltage due to the temperature rise, and further than the subsequent decrease in temperature can output a second voltage (essentially equivalent to the first, if returning to the same state). This can provide confirmation of a complete temperature system.

Fig. 6c shows the sensor 600' of Fig. 6b in a plan view form, where the switch device 610' has a octagon structure. As shown, the switch device 610; comprises a source 611', which is connected to the substrate of the switch 610' on the side of the second region, and a drain 612' connected to the substrate on the side of the first region. A gate contact 613' is provided and connects to the first n-doped layer (i.e. the second gate structure) and the thermocouple is connected to a write contact 614' which is connected to the first p-doped layer (i.e. the first gate structure).

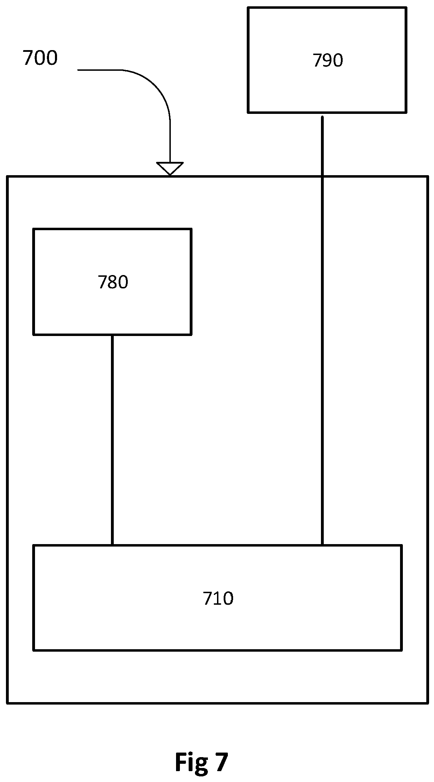

Fig. 7 schematically depicts a system comprising a sensor 700 comprising a first switch device 710 and a first voltage generation device 780 operably connected to the switch device 710. This has the same structure and functionality as the sensor 600 of Fig. 6, but the system additionally includes a reader 790 configured to determine the state of the switch device(s) 710 in the sensor 700. The reader 790 is accordingly configured to take a reading indicative of the location of a plurality of charge carriers within the or each switch device 710. This may be through the application of voltage to the or each switch device 710. The reader 790 may be releasably connectable to the sensor 700 so that the reader 790 is not always present. In some embodiments, this may be wirelessly connected and in others there may be a physical connection.

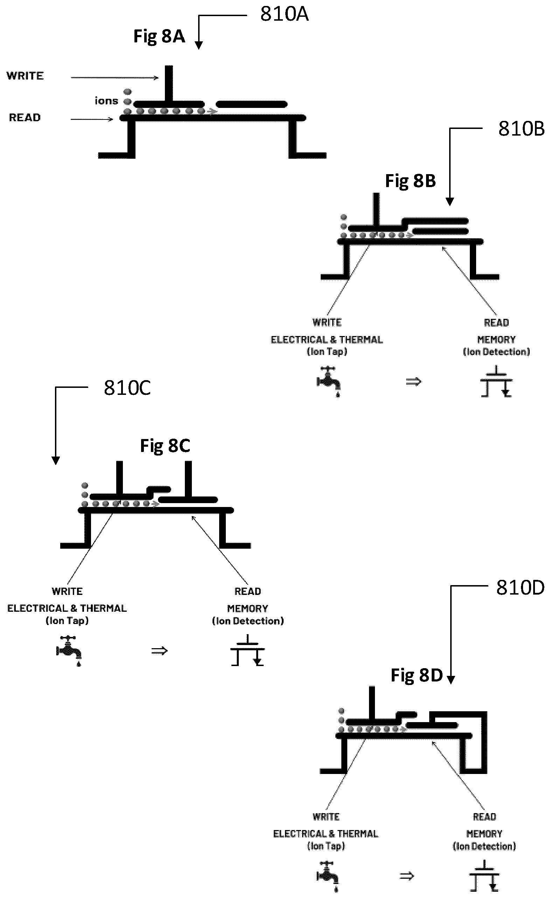

Figs. 8a-8d schematically depict the principle of the switch devices disclosed herein. The switch devices act at its most basic level as a dual gate FET where there is a first gate formed by the first p-doped layer and the substrate with the first region of the conduction layer therebetween; a second gate formed by the first n-doped layer and the substrate with the second region of the conduction layer therebetween; and a gate oxide formed by the conduction layer in which a channel can be formed when the charge carriers break out of the first region and punch through to the second region.

Fig. 8a provides a switch device 810A in the initial state where the ions are in the first region R1 and have not yet moved into the second region. The first gate acts as a "write" where the application of a voltage leads to the reduction or elimination of the electric field between the p-n junction to the extent that the charge carriers can move into the second region R2.

Fig. 8b shows a switch device 810B configured as a floating gate structure. In such a configuration, the first n-doped layer (i.e. forming the second gate structure) may be electrically isolated. Instead, a further gate - in the form of a further doped polysilicon layer - can be provided above the first n-doped layer.

Fig. 8c shows a switch device 810C configured as a driven gate structure. In such a configuration, the first n-doped layer (i.e. forming the second gate structure) can be provided with a second gate contact. This can be used to apply a voltage across the second gate structure and determine a read of the state of the switch device. The first p-doped layer may overlay the first n-doped layer in such a structure.

Fig. 8d shows a switch device 810D configured as a shorted gate structure. **In** such a configuration, the first n-doped layer (i.e. forming the second gate structure) can be provided with a second gate contact which can be connected to the source.

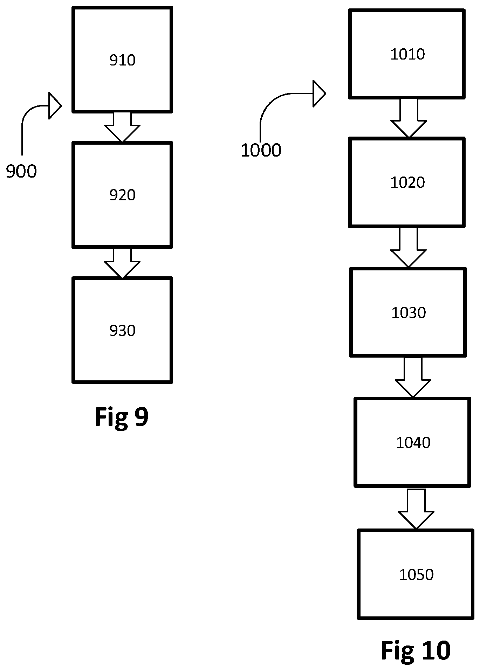

Fig. 9 depicts a method 900 of determining whether a physical event of a first magnitude has occurred, the method comprising: providing a sensor according to any of the embodiments disclosed herein 910; exposing 920 the sensor to an environment in which a first physical event may occur such that a voltage at or above the threshold voltage is produced by the voltage generation device; and interrogating 930 the sensor to determine whether the first physical event occurred.

Fig. 10 depicts a method 1000 of 18. A method of manufacturing a switch device, the method comprising: providing a substrate 1010; depositing a conduction layer 1020 on the substrate, wherein the conduction layer extends from a first region adjacent the first p-doped layer to a second region adjacent the first n-doped layer, wherein the conduction layer comprises a plurality of charge carriers moveable within the conduction layer and wherein, in an initial state, the concentration of charge carriers in the first region is higher than in the second region; and forming a p-n junction 1030 by depositing a first p-doped layer on the substrate adjacent the first region and depositing a first n-doped layer on the substrate adjacent the second region and such that first n-doped layer opposes the first p-doped layer. The first p-doped layer is vertically offset relative to the first n-doped layer to provide an offset region adjacent the first p-doped layer in which a plane parallel to the surface of the substrate extends through the offset region and the first n-doped layer; and wherein a part of the conduction layer defining at least a part of the first region is provided in the offset region such that an electric field generated by the p-n junction opposes the migration of the charge carriers from the first region to the second region. It should be noted that the description and drawings merely illustrate the principles of the proposed methods and systems. Furthermore, all examples and embodiments outlined in the present document are principally intended expressly to be only for explanatory purposes to help the reader in understanding the principles of the proposed methods and systems. Furthermore, all statements herein providing principles, aspects, and embodiments, as well as specific examples thereof, are intended to encompass equivalents thereof.

## Claims

1. A switch device (100; 200; 610; 710; 810A-D), comprising:
a substrate (110;..510);
a p-n junction comprising a first p-doped layer (170;...; 570) provided on the substrate (110;..510) and a first n-doped layer (150;...; 550) provided on the substrate (110;..510) and opposing the first p-doped layer (170;...; 570);
a conduction layer (140;...; 540) provided on the substrate (110;..510) and extending from a first region (R1) adjacent the p-doped layer to a second region adjacent the n-doped layer (150;...; 550),
wherein the conduction layer (140;...; 540) comprises a plurality of charge carriers moveable within the conduction layer (140;...; 540), **characterised in that**, in an initial state, the concentration of charge carriers in the first region (R1) is higher than in the second region (R2); and
wherein the first p-doped layer (170;...; 570) is vertically offset relative to the first n-doped layer (150;...; 550) to provide an offset region (155; 255) adjacent the first p-doped layer (170;...; 570) in which a plane parallel to the surface of the substrate (110;..510) extends through the offset region (155; 255) and the first n-doped layer (150;...; 550); and
**in that** a part of the conduction layer (140;...; 540) defining at least a part of the first region (R1) is provided in the offset region (155; 255) such that an electric field generated by the p-n junction opposes the migration of the charge carriers from the first region (R1) to the second region (R2).

2. The switch device (100; 200; 610; 710; 810A-D) according to claim 1, wherein the first p-doped layer (170;... ; 570) comprises an overlap region (275) in which a plane parallel to the surface of the substrate (110;..510) extends through the overlap region (275) and the first n-doped layer (150;...; 550).

3. The switch device (100; 200; 610; 710; 810A-D) according to any preceding claim, wherein the conduction layer (140;...; 540) is provided between the first p-doped layer (170;...; 570) and the substrate (110;..510) and between the first n-doped layer (150;...; 550) and the substrate (110;..510).

4. The switch device (100; 200; 610; 710; 810A-D) according to any preceding claim, wherein the first p-doped layer (170;...; 570) is provided directly on the conduction layer (140;...; 540) in the offset region (155; 255).

5. The switch device (100; 200; 610; 710; 810A-D) according to any preceding claim, wherein the conduction layer (140;...; 540) comprises an oxide, optionally wherein the conduction layer (140;...; 540) comprises tetraethyl orthosilicate (TEOS).

6. The switch device (100; 200; 610; 710; 810A-D) according to any preceding claim, wherein the conduction layer (140;...; 540) comprises:
a first sub-layer (340; 440; 540) comprising at least a part of the first region (R1); and
a second sub-layer (330; 430; 530) located adjacent the first sub-layer (340; 440; 540) and extending from the first region (R1) to the second region (R2), optionally wherein the second sub-layer (330; 430; 530) comprises the second region (R2).

7. The switch device (100; 200; 610; 710; 810A-D) according to claim 6, wherein the first sub-layer (340; 440; 540) comprises tetraethyl orthosilicate (TEOS) and wherein the second sub-layer (330; 430; 530) comprises an oxide, wherein the oxide is different to the oxide of the first sub-layer (340; 440; 540).

8. The switch device (100; 200; 610; 710; 810A-D) according to any preceding claim, wherein the switch device (100; 200; 610; 710; 810A-D) is configured such that a voltage applied across a first gate structure formed by the first p-doped layer (170;...; 570) and the substrate (110;..510) above a threshold voltage allows charge carriers to migrate from the first region (R1) to the second region (R2).

9. A sensor (600; 700) for detecting a physical event, comprising:
at least one switch device (100; 200; 610; 710; 810A-D) according to any preceding claim; and
a voltage generation device (680; 780) operably connected to the switch device (100; 200; 610; 710; 810A-D) so as to apply a voltage to the switch device (100; 200; 610; 710; 810A-D),
wherein the switch device (100; 200; 610; 710; 810A-D) is configured such that the voltage applied across a first gate structure formed by the first p-doped layer (170;...; 570) and the substrate (110;..510) above a threshold voltage allows charge carriers to migrate from the first region (R1) to the second region (R2) wherein the voltage generation device (680; 780) is configured such that a physical event of a first magnitude causes the generation of a voltage above the threshold voltage.

10. The sensor (600; 700) of claim 9, wherein the voltage generation device (680; 780) is configured to generate a voltage in response to a thermal event of a first magnitude.

11. The sensor (600; 700) of claim 9 or claim 10, wherein the sensor (600; 700) comprises a plurality of switch devices (100; 200; 610; 710; 810A-D) according to any of claims 1 to 8, wherein each of the switch devices (100; 200; 610; 710; 810A-D) in connected in series forming a switch device set and wherein the voltage generation device (680; 780) is operably connected to each switch device (100; 200; 610; 710; 810A-D) of the switch device set.

12. The sensor (600; 700) of claim 11, wherein the voltage generation device (680; 780) is configured to generate a first voltage in response to a first change in temperature from a first temperature to a second temperature, the first change being of a first magnitude sufficient to generate a voltage above the threshold voltage; and
wherein the voltage generation device (680; 780) is further configured to generate a second voltage in response to a second change in temperature from the second temperature to the first temperature, the second change being of a second magnitude sufficient to generate a voltage above the threshold voltage.

13. A method (900) of determining whether a physical event of a first magnitude has occurred, the method comprising:
providing (910) a sensor (600; 700) according to any of claims 9 to 12;
exposing (920) the sensor (600; 700) to an environment in which a first physical event may occur such that a voltage at or above the threshold voltage is produced by the voltage generation device (680; 780); and
interrogating (930) the sensor (600; 700) to determine whether the first physical event occurred.

14. The method (900) of claim 13, wherein interrogating the sensor (600; 700) to determine whether the first physical event occurred comprises:
applying a voltage to the at least one switch device (100; 200; 610; 710; 810A-D) to determine whether charge carriers have migrated from the first region (R1) to the second region (R2).

15. A method (1000) of manufacturing a switch device (100; 200; 610; 710; 810A-D), the method comprising:
providing (1010) a substrate (110;..510);
depositing (1020) a conduction layer (140; ...; 540) on the substrate (110;..510), wherein the conduction layer (140;...; 540) extends from a first region (R1) adjacent the first p-doped layer (170;...; 570) to a second region (R2) adjacent the first n-doped layer (150;...; 550), wherein the conduction layer (140;...; 540) comprises a plurality of charge carriers moveable within the conduction layer (140;...; 540); and and
forming (1030) a p-n junction by depositing a first p-doped layer (170;...; 570) on the substrate (110;..510) adjacent the first region (R1) and depositing a first n-doped layer (150;...; 550) on the substrate (110;..510) adjacent the second region (R2) and such that first n-doped layer (150;...; 550) opposes the first p-doped layer (170;...; 570),
**characterised in that** in an initial state, the concentration of charge carriers in the first region (R1) is higher than in the second region (R2); and the first p-doped layer (170;...; 570) is vertically offset relative to the first n-doped layer (150;...; 550) to provide an offset region (155; 255) adjacent the first p-doped layer (170;...; 570) in which a plane parallel to the surface of the substrate (110;..510) extends through the offset region (155; 255) and the first n-doped layer (150;...; 550); and
**in that** a part of the conduction layer (140;...; 540) defining at least a part of the first region (R1) is provided in the offset region (155; 255) such that an electric field generated by the p-n junction opposes the migration of the charge carriers from the first region (R1) to the second region (R2).

## Patentansprüche

1. Schaltvorrichtung (100; 200; 610; 710; 810A-D), umfassend:
ein Substrat (110;..510);
einen pn-Übergang, der eine erste p-dotierte Schicht (170;...; 570), die auf dem Substrat (110;...510) bereitgestellt ist, und eine erste n-dotierte Schicht (150;...; 550) umfasst, die auf dem Substrat (110;...510) bereitgestellt ist und der ersten p-dotierten Schicht (170;...; 570) gegenüberliegt;
eine Leitschicht (140;... ; 540), die auf dem Substrat (110;...510) bereitgestellt ist und sich von einer ersten Region (R1) benachbart zu der p-dotierten Schicht zu einer zweiten Region benachbart zu der n-dotierten Schicht (150;...; 550) erstreckt,
wobei die Leitschicht (140;...; 540) eine Vielzahl von Ladungsträgern umfasst, die innerhalb der Leitschicht (140;...; 540) beweglich sind, **dadurch gekennzeichnet, dass**
in einem Ausgangszustand die Konzentration von Ladungsträgern in der ersten Region (R1) höher als in der zweiten Region (R2) ist; und
wobei die erste p-dotierte Schicht (170;...; 570) in Bezug auf die erste n-dotierte Schicht (150;...; 550) vertikal versetzt ist, um eine Versatzregion (155; 255) benachbart zu der ersten p-dotierten Schicht (170;...; 570) bereitzustellen, in der sich eine Ebene parallel zu der Oberfläche des Substrats (110;...510) durch die Versatzregion (155; 255) und die erste n-dotierte Schicht (150;...; 550) erstreckt; und
dadurch, dass ein Teil der Leitschicht (140;...; 540), der mindestens einen Teil der ersten Region (R1) definiert, in der Versatzregion (155; 255) bereitgestellt ist, sodass ein elektrisches Feld, das durch den pn-Übergang erzeugt wird, der Migration der Ladungsträger von der ersten Region (R1) zu der zweiten Region (R2) entgegenwirkt.

2. Schaltvorrichtung (100; 200; 610; 710; 810A-D) nach Anspruch 1, wobei die erste p-dotierte Schicht (170;...; 570) eine Überlappungsregion (275) umfasst, in der sich eine Ebene parallel zu der Oberfläche des Substrats (110;...510) durch die Überlappungsregion (275) und die erste n-dotierte Schicht (150;...; 550) erstreckt.

3. Schaltvorrichtung (100; 200; 610; 710; 810A-D) nach einem vorhergehenden Anspruch, wobei die Leitschicht (140;...; 540) zwischen der ersten p-dotierten Schicht (170;...; 570) und dem Substrat (110;...510) und zwischen der ersten n-dotierten Schicht (150;...; 550) und dem Substrat (110;...510) bereitgestellt ist.

4. Schaltvorrichtung (100; 200; 610; 710; 810A-D) nach einem vorhergehenden Anspruch, wobei die erste p-dotierte Schicht (170;...; 570) direkt auf der Leitschicht (140;...; 540) in der Versatzregion (155; 255) bereitgestellt ist.

5. Schaltvorrichtung (100; 200; 610; 710; 810A-D) nach einem vorhergehenden Anspruch, wobei die Leitschicht (140;...; 540) ein Oxid umfasst, wobei die Leitschicht (140;...; 540) optional Tetraethylorthosilikat (TEOS) umfasst.

6. Schaltvorrichtung (100; 200; 610; 710; 810A-D) nach einem vorhergehenden Anspruch, wobei die Leitschicht (140;,...; 540) Folgendes umfasst:
eine erste Unterschicht (340; 440; 540), die mindestens einen Teil der ersten Region (R1) umfasst; und
eine zweite Unterschicht (330; 430; 530), die benachbart zu der ersten Unterschicht (340; 440; 540) angeordnet ist und sich von der ersten Region (R1) zu der zweiten Region (R2) erstreckt, wobei die zweite Unterschicht (330; 430; 530) optional die zweite Region (R2) umfasst.

7. Schaltvorrichtung (100; 200; 610; 710; 810A-D) nach Anspruch 6, wobei die erste Unterschicht (340; 440; 540) Tetraethylorthosilikat (TEOS) umfasst und wobei die zweite Unterschicht (330; 430; 530) ein Oxid umfasst, wobei sich das Oxid von dem Oxid der ersten Unterschicht (340; 440; 540) unterscheidet.

8. Schaltvorrichtung (100; 200; 610; 710; 810A-D) nach einem vorhergehenden Anspruch, wobei die Schaltvorrichtung (100; 200; 610; 710; 810A-D) so konfiguriert ist, dass eine Spannung, die über einer ersten Gate-Struktur, die durch die erste p-dotierte Schicht (170;...; 570) und das Substrat (110;...510) ausgebildet wird, über einer Schwellenspannung angelegt wird, ermöglicht, dass Ladungsträger von der ersten Region (R1) zu der zweiten Region (R2) migrieren.

9. Sensor (600; 700) zum Detektieren eines physikalischen Ereignisses, umfassend:
mindestens eine Schaltvorrichtung (100; 200; 610; 710; 810A-D) nach einem vorhergehenden Anspruch; und
eine Spannungserzeugungsvorrichtung (680; 780), die mit der Schaltvorrichtung (100; 200; 610; 710; 810A-D) wirkverbunden ist, um eine Spannung an die Schaltvorrichtung (100; 200; 610; 710; 810A-D) anzulegen,
wobei die Schaltvorrichtung (100; 200; 610; 710; 810A-D) so konfiguriert ist, dass die Spannung, die über einer ersten Gate-Struktur, die durch die erste p-dotierte Schicht (170;...; 570) und das Substrat (110;...510) ausgebildet wird, über einer Schwellenspannung angelegt wird, ermöglicht, dass Ladungsträger von der ersten Region (R1) zu der zweiten Region (R2) migrieren, wobei die Spannungserzeugungsvorrichtung (680; 780) so konfiguriert ist, dass ein physikalisches Ereignis einer ersten Größe die Erzeugung einer Spannung über der Schwellenspannung bewirkt.

10. Sensor (600; 700) nach Anspruch 9, wobei die Spannungserzeugungsvorrichtung (680; 780) dazu konfiguriert ist, eine Spannung als Reaktion auf ein thermisches Ereignis einer ersten Größe zu erzeugen.

11. Sensor (600; 700) nach Anspruch 9 oder Anspruch 10, wobei der Sensor (600; 700) eine Vielzahl von Schaltvorrichtungen (100; 200; 610; 710; 810A-D) nach einem der Ansprüche 1 bis 8 umfasst, wobei jede der Schaltvorrichtungen (100; 200; 610; 710; 810A-D) in Reihe verbunden ist, wodurch ein Schaltvorrichtungssatz ausgebildet wird, und wobei die Spannungserzeugungsvorrichtung (680; 780) mit jeder Schaltvorrichtung (100; 200; 610; 710; 810A-D) des Schaltvorrichtungssatzes wirkverbunden ist.

12. Sensor (600; 700) nach Anspruch 11, wobei die Spannungserzeugungsvorrichtung (680; 780) dazu konfiguriert ist, eine erste Spannung als Reaktion auf eine erste Änderung der Temperatur von einer ersten Temperatur zu einer zweiten Temperatur zu erzeugen, wobei die erste Änderung eine erste Größe aufweist, die ausreicht, um eine Spannung über der Schwellenspannung zu erzeugen; und
wobei die Spannungserzeugungsvorrichtung (680; 780) ferner dazu konfiguriert ist, eine zweite Spannung als Reaktion auf eine zweite Änderung der Temperatur von der zweiten Temperatur zu der ersten Temperatur zu erzeugen, wobei die zweite Änderung eine zweite Größe aufweist, die ausreicht, um eine Spannung über der Schwellenspannung zu erzeugen.

13. Verfahren (900) zum Bestimmen, ob ein physikalisches Ereignis einer ersten Größe aufgetreten ist, wobei das Verfahren Folgendes umfasst:
Bereitstellen (910) eines Sensors (600; 700) nach einem der Ansprüche 9 bis 12;
Aussetzen (920) des Sensors (600; 700) gegenüber einer Umgebung, in der ein erstes physikalisches Ereignis auftreten kann, sodass eine Spannung bei oder über der Schwellenspannung durch die Spannungserzeugungsvorrichtung (680; 780) erzeugt wird; und
Abfragen (930) des Sensors (600; 700), um zu bestimmen, ob das erste physikalische Ereignis aufgetreten ist.

14. Verfahren (900) nach Anspruch 13, wobei das Abfragen des Sensors (600; 700), um zu bestimmen, ob das erste physikalische Ereignis aufgetreten ist, Folgendes umfasst:
Anlegen einer Spannung an die mindestens eine Schaltvorrichtung (100; 200; 610; 710; 810A-D), um zu bestimmen, ob Ladungsträger von der ersten Region (R1) zu der zweiten Region (R2) migriert sind.

15. Verfahren (1000) zum Herstellen einer Schaltvorrichtung (100; 200; 610; 710; 810A-D), wobei das Verfahren Folgendes umfasst:
Bereitstellen (1010) eines Substrats (110;..510);
Abscheiden (1020) einer Leitschicht (140;...; 540) auf dem Substrat (110;...510), wobei sich die Leitschicht (140;...; 540) von einer ersten Region (R1) benachbart zu der ersten p-dotierten Schicht (170;...; 570) zu einer zweiten Region (R2) benachbart zu der ersten n-dotierten Schicht (150;...; 550) erstreckt, wobei die Leitschicht (140;...; 540) eine Vielzahl von Ladungsträgern umfasst, die innerhalb der Leitschicht (140;...; 540) beweglich sind; und
und
Ausbilden (1030) eines pn-Übergangs durch Abscheiden einer ersten p-dotierten Schicht (170;...; 570) auf dem Substrat (110;...510) benachbart zu der ersten Region (R1) und Abscheiden einer ersten n-dotierten Schicht (150;...; 550) auf dem Substrat (110;...510) benachbart zu der zweiten Region (R2) und derart, dass die erste n-dotierte Schicht (150;...; 550) der ersten p-dotierten Schicht (170;...; 570) gegenüberliegt,
**dadurch gekennzeichnet, dass** in einem Ausgangszustand die Konzentration von Ladungsträgern in der ersten Region (R1) höher als in der zweiten Region (R2) ist; und
die erste p-dotierte Schicht (170;...; 570) in Bezug auf die erste n-dotierte Schicht (150;...; 550) vertikal versetzt ist, um eine Versatzregion (155; 255) benachbart zu der ersten p-dotierten Schicht (170;...; 570) bereitzustellen, in der sich eine Ebene parallel zu der Oberfläche des Substrats (110;...510) durch die Versatzregion (155; 255) und die erste n-dotierte Schicht (150;...; 550) erstreckt; und
dadurch, dass ein Teil der Leitschicht (140;...; 540), der mindestens einen Teil der ersten Region (R1) definiert, in der Versatzregion (155; 255) bereitgestellt ist, sodass ein elektrisches Feld, das durch den pn-Übergang erzeugt wird, der Migration der Ladungsträger von der ersten Region (R1) zu der zweiten Region (R2) entgegenwirkt.

## Revendications

1. Dispositif de commutation (100 ; 200 ; 610 ; 710 ; 810A-D), comprenant :
un substrat (110 ;..510) ;
une jonction p-n comprenant une première couche dopée p (170 ;... ; 570) prévue sur le substrat (110 ;..510) et une première couche dopée n (150 ;... ; 550) prévue sur le substrat (110 ;..510) et opposée à la première couche dopée p (170 ;... ; 570) ;
une couche de conduction (140 ;... ; 540) prévue sur le substrat (110 ;..510) et s'étendant à partir d'une première zone (R1) adjacente à la couche dopée p jusqu'à une seconde zone adjacente à la couche dopée n (150 ;... ; 550),
ladite couche de conduction (140 ;... ; 540) comprenant une pluralité de porteurs de charge mobiles à l'intérieur de la couche de conduction (140 ;... ; 540), **caractérisé en ce que**,
dans un état initial, la concentration de porteurs de charge
dans la première zone (R1) est plus élevée que dans la seconde zone (R2) ; et
ladite première couche dopée p (170 ;... ; 570) étant décalée verticalement par rapport à la première couche dopée n (150 ;... ; 550) pour fournir une zone de décalage (155 ; 255) adjacente à la première couche dopée p (170 ;... ; 570) dans laquelle un plan parallèle à la surface du substrat (110 ;..510) s'étend à travers la zone de décalage (155 ; 255) et la première couche dopée n (150 ;... ; 550) ; et
**en ce qu'**une partie de la couche de conduction (140 ;... ; 540) définissant au moins une partie de la première zone (R1) est prévue dans la zone de décalage (155 ; 255) de sorte qu'un champ électrique généré par la jonction p-n s'oppose à la migration des porteurs de charge de la première zone (R1) vers la seconde zone (R2).

2. Dispositif de commutation (100 ; 200 ; 610 ; 710 ; 810A-D) selon la revendication 1, ladite première couche dopée p (170 ;... ; 570) comprenant une zone de chevauchement (275) dans laquelle un plan parallèle à la surface du substrat (110 ;..510) s'étend à travers la zone de chevauchement (275) et la première couche dopée n (150 ;... ; 550).

3. Dispositif de commutation (100 ; 200 ; 610 ; 710 ; 810A-D) selon une quelconque revendication précédente, ladite couche de conduction (140 ;... ; 540) étant prévue entre la première couche dopée p (170 ;... ; 570) et le substrat (110 ;..510) et entre la première couche dopée n (150 ;... ; 550) et le substrat (110 ;..510).

4. Dispositif de commutation (100 ; 200 ; 610 ; 710 ; 810A-D) selon une quelconque revendication précédente, ladite première couche dopée p (170 ;... ; 570) étant prévue directement sur la couche de conduction (140 ;... ; 540) dans la zone de décalage (155 ; 255).

5. Dispositif de commutation (100 ; 200 ; 610 ; 710 ; 810A-D) selon une quelconque revendication précédente, ladite couche de conduction (140 ;... ; 540) comprenant un oxyde, éventuellement ladite couche de conduction (140 ;... ; 540) comprenant de l'orthosilicate de tétraéthyle (TEOS).

6. Dispositif de commutation (100 ; 200 ; 610 ; 710 ; 810A-D) selon une quelconque revendication précédente, ladite couche de conduction (140 ;,.. ; 540) comprenant :
une première sous-couche (340 ; 440 ; 540) comprenant au moins une partie de la première zone (R1) ; et
une seconde sous-couche (330 ; 430 ; 530) située adjacente à la première sous-couche (340 ; 440 ; 540) et s'étendant à partir de la première zone (R1) jusqu'à la seconde zone (R2), éventuellement ladite seconde sous-couche (330 ; 430 ; 530) comprenant la seconde zone (R2).

7. Dispositif de commutation (100 ; 200 ; 610 ; 710 ; 810A-D) selon la revendication 6, ladite première sous-couche (340 ; 440 ; 540) comprenant de l'orthosilicate de tétraéthyle (TEOS) et ladite seconde sous-couche (330 ; 430 ; 530) comprenant un oxyde, ledit oxyde étant différent de l'oxyde de la première sous-couche (340 ; 440 ; 540).

8. Dispositif de commutation (100 ; 200 ; 610 ; 710 ; 810A-D) selon une quelconque revendication précédente, ledit dispositif de commutation (100 ; 200 ; 610 ; 710 ; 810A-D) étant configuré de sorte qu'une tension appliquée à travers une première structure de grille formée par la première couche dopée p (170 ;... ; 570) et le substrat (110 ;..510) supérieure à une tension seuil permette à des porteurs de charge de migrer de la première zone (R1) vers la seconde zone (R2).

9. Capteur (600 ; 700) destiné à détecter un événement physique, comprenant :
au moins un dispositif de commutation (100 ; 200 ; 610 ; 710 ; 810A-D) selon une quelconque revendication précédente ; et
un dispositif de génération de tension (680 ; 780) connecté fonctionnellement au dispositif de commutation (100 ; 200 ; 610 ; 710 ; 810A-D) de façon à appliquer une tension au dispositif de commutation (100 ; 200 ; 610 ; 710 ; 810A-D),
ledit dispositif de commutation (100 ; 200 ; 610 ; 710 ; 810A-D) étant configuré de sorte que la tension appliquée à travers une première structure de grille formée par la première couche dopée p (170 ;... ; 570) et le substrat (110 ;..510) supérieure à une tension seuil permette aux porteurs de charge de migrer de la première zone (R1) vers la seconde zone (R2), ledit dispositif de génération de tension (680 ; 780) étant configuré de sorte qu'un événement physique d'une première amplitude entraîne la génération d'une tension supérieure à la tension seuil.

10. Capteur (600 ; 700) de la revendication 9, ledit dispositif de génération de tension (680 ; 780) étant configuré pour générer une tension en réponse à un événement thermique d'une première amplitude.

11. Capteur (600 ; 700) de la revendication 9 ou de la revendication 10, ledit capteur (600 ; 700) comprenant une pluralité de dispositifs de commutation (100 ; 200 ; 610 ; 710 ; 810A-D) selon l'une quelconque des revendications 1 à 8, chacun des dispositifs de commutation (100 ; 200 ; 610 ; 710 ; 810A-D) étant connecté en série formant un ensemble de dispositifs de commutation et ledit dispositif de génération de tension (680 ; 780) étant connecté fonctionnellement à chaque dispositif de commutation (100 ; 200 ; 610 ; 710 ; 810A-D) de l'ensemble de dispositifs de commutation.

12. Capteur (600 ; 700) de la revendication 11, ledit dispositif de génération de tension (680 ; 780) étant configuré pour générer une première tension en réponse à un premier changement de température d'une première température à une seconde température, ledit premier changement étant d'une première amplitude suffisante pour générer une tension supérieure à la tension seuil ; et
ledit dispositif de génération de tension (680 ; 780) étant en outre configuré pour générer une seconde tension en réponse à un second changement de température de la seconde température à la première température, le second changement étant d'une seconde amplitude suffisante pour générer une tension supérieure à la tension seuil.

13. Procédé (900) de détermination pour savoir si un événement physique d'une première amplitude s'est produit, le procédé comprenant :
la fourniture (910) d'un capteur (600 ; 700) selon l'une quelconque des revendications 9 à 12 ;
l'exposition (920) du capteur (600 ; 700) à un environnement dans lequel un premier événement physique peut se produire de sorte qu'une tension supérieure ou égale à la tension seuil soit produite par le dispositif de génération de tension (680 ; 780) ; et
l'interrogation (930) du capteur (600 ; 700) pour déterminer si le premier événement physique s'est produit.

14. Procédé (900) de la revendication 13, ladite interrogation du capteur (600 ; 700) pour déterminer si le premier événement physique s'est produit comprenant :
l'application d'une tension à l'au moins un dispositif de commutation (100 ; 200 ; 610 ; 710 ; 810A-D) pour déterminer si des porteurs de charge ont migré de la première zone (R1) à la seconde zone (R2).

15. Procédé (1000) de fabrication d'un dispositif de commutation (100 ; 200 ; 610 ; 710 ; 810A-D), le procédé comprenant :
la fourniture (1010) d'un substrat (110 ;..510) ;
le dépôt (1020) d'une couche de conduction (140 ;.... ; 540) sur le substrat (110 ;..510), ladite couche de conduction (140 ;... ; 540) s'étendant à partir d'une première zone (R1) adjacente à la première couche dopée p (170 ;... ; 570) jusqu'à une seconde zone (R2) adjacente à la première couche dopée n (150 ;... ; 550), ladite couche de conduction (140 ;... ; 540) comprenant une pluralité de porteurs de charge mobiles à l'intérieur de la couche de conduction (140 ;... ; 540) ; et
et
la formation (1030) d'une jonction p-n en déposant une première couche dopée p (170 ;... ; 570) sur le substrat (110 ;..510) adjacente à la première zone (R1) et en déposant une première couche dopée n (150 ;... ; 550) sur le substrat (110 ;..510) adjacente à la seconde zone (R2) et de sorte que la première couche dopée n (150 ;... ; 550) s'oppose à la première couche dopée p (170 ;... ; 570),
**caractérisé en ce que** dans un état initial, la concentration de porteurs de charge dans la première zone (R1) est plus élevée que dans la seconde zone (R2) ; et la première couche dopée p (170 ;... ; 570) est décalée verticalement par rapport à la première couche dopée n (150 ;... ; 550) pour fournir une zone de décalage (155 ; 255) adjacente à la première couche dopée p (170 ;... ; 570) dans laquelle un plan parallèle à la surface du substrat (110 ;. ,510) s'étend à travers la zone de décalage (155 ; 255) et la première couche dopée n (150 ;... ; 550) ; et
**en ce qu'**une partie de la couche de conduction (140 ;... ; 540) définissant au moins une partie de la première zone (R1) est prévue dans la zone de décalage (155 ; 255) de sorte qu'un champ électrique généré par la jonction p-n s'oppose à la migration des porteurs de charge de la première zone (R1) vers la seconde zone (R2).
